# EUROPÄISCHE PATENTSCHRIFT

(11) **EP 3 374 776 B1**
(45) Veröffentlichungstag und Bekanntmachung des Hinweises auf die Patenterteilung: **18.12.2019**
(21) Anmeldenummer: 17771352.6
(22) Anmeldetag: 05.09.2017
(51) Int. Cl.: G01R 31/02, G01R 15/16

(54) **VERFAHREN UND MESSVORRICHTUNG ZUM ÜBERPRÜFEN EINES KABELBAUMES**
METHOD AND MEASURING APPARATUS FOR CHECKING A CABLE HARNESS
PROCÉDÉ ET DISPOSITIF DE MESURE POUR VÉRIFIER UN HARNAIS DE CÂBLES

(30) Priorität: 07.09.2016 DE 102016116695
(43) Veröffentlichungstag der Anmeldung: 19.09.2018
(60) Teilanmeldung: 18212564.1
(73) Patentinhaber: ESPI Logistics GmbH, 91126 Schwabach (DE)
(72) Erfinder: LOCHMANN, Rüdiger, 91126 Schwabach (DE)
(74) Vertreter: Negendanck, Matthias
(86) Internationale Anmeldenummer: PCT/EP2017/072162
(87) Internationale Veröffentlichungsnummer: WO 2018/046465

(56) Entgegenhaltungen:
- AT-B- 357 634
- FR-A1- 2 928 740
- US-A- 5 570 010

## Beschreibung

Die Erfindung betrifft ein Verfahren und eine Messvorrichtung zum Überprüfen eines Kabelbaumes.

Als Kabelbaum wird die Zusammenfassung verschiedenartiger elektrischer Leitungen (auch "Adern" genannt) zu einem Strang bezeichnet. Dieser stellt die Verbindungen - z.B. auch über Abzweigungen - zwischen verschiedenen elektrischen Komponenten z.B. in Fahrzeugen oder Maschinen her. In der Regel werden Kabelbäume nach der Fertigung auf Vollständigkeit (korrekte Verbindungen) und Kurzschluss getestet. Übliche Kabelbaumtester (z.B. http://www.t-s-k.de/ fileadmin/ user_upload/ Flyer_2013/ Kabeltester/ K_Flyer_CT35_de.pdf) benötigen an beiden Seiten der Adern des Kabelbaums Steckverbindungen z.B. für die Messung des Durchgangswiderstandes. Es gibt jedoch auch Kabelbäume, die vorgefertigt werden und zunächst nur einseitig mit Steckern bestückt sind. Die zweite Seite der Leitungen wird erst bei der Endmontage an Stecker angeschlossen. Diese Kabelbäume haben offene Adern (Leitungsenden ohne Steckverbinder etc.), die beim Test nur einzeln und damit sehr aufwändig kontaktiert werden können und sich somit nur mit erheblichem Aufwand von üblichen Kabelbaumtestern testen lassen.

Aus dem Patent US 5,570,010 A ist es bekannt, ein bestimmtes Kabel unter einer Vielzahl von in einem Trog untergebrachten Kabeln zu identifizieren. Dabei verbindet ein Signalanlegeabschnitt drei verschiedene Frequenzsignale, die durch einen Schwingkreisabschnitt erzeugt werden, durch eine Potentialsignal-Misch- und Anlegeschaltung und legt sie an den Leiter des bestimmten Kabels an. In einem Erfassungsabschnitt erfasst eine Erfassungsschaltung das Verbundsignal über eine Elektrode, die mit einem bestimmten Kabel elektrostatisch gekoppelt ist. Eine Verstärkungsschaltung unterzieht das Verbundsignal einer Verstärkungseinstellung, und eine Signalidentifizierungsschaltung identifiziert das bestimmte Kabel aus dem zusammengesetzten Signal.

Aus der DE 691 24 244 T2 ist ein System zur Feststellung des Vorhandenseins und/oder zur Identifizierung von Adern an einem Ende eines Kabels mit einem Wechselstrom-Signalgenerator zum selektiven Anlegen eines Wechselstromsignals an eine oder mehrere Adern am anderen Ende des Kabels bekannt, mit wenigstens einer Elektrode zur Feststellung des Wechselstromsignals an dem einen Ende des Kabels, wobei das Wechselstromsignal kapazitiv mit der Elektrode gekoppelt ist, und mit einer mit der Elektrode verbundenen elektronischen Schaltung zur Auswertung des Wechselstromsignals, wobei die Elektrode ein leitendes Rohr vorbestimmter Länge umfaßt und ein am Boden geschlossenes isolierendes Rohr aus Keramik, das einen elektrisch isolierenden Hohlraum zur Einbringung einer Ader an dem einen Ende des Kabels in das Rohr (34) eingesetzt ist, derart, daß die Ader elektrisch von der Elektrode isoliert ist.

### Der Erfindung liegt die Aufgabe zugrunde, die Überprüfung eines Kabelbaumes zu verbessern

Diese Aufgabe wird durch ein Verfahren gemäß Patentanspruch 1 gelöst. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Das Verfahren dient zum Überprüfen eines Kabelbaumes, wobei der Kabelbaum eine Mehrzahl von elektrischen Leitungen - auch "Adern" genannt - enthält. Gemäß dem Verfahren wird ein Prüfabschnitt des Kabelbaumes gewählt. Der Prüfabschnitt enthält ein Leitungsbündel mit wenigstens einer der Leitungen. Eine Elektrode einer Messvorrichtung wird am Prüfabschnitt angeordnet. Zumindest ein Teil der Elektrode ist als Mehrfachstruktur ausgebildet. Die Mehrfachstruktur weist mindestens zwei Messkammern auf. In jede der Messkammern ist mindestens eine der Leitungen des Leitungsbündels einlegbar, wie weiter unten näher erläutert wird. Die Anordnung erfolgt derart, dass die Elektrode mit jeder der Leitungen des Leitungsbündels im Prüfabschnitt einen jeweiligen Kondensator bildet. Insbesondere wird ein Kondensator mit möglichst großer Kapazität gebildet, um später entsprechend große Messsignale erzielen zu können. Eine der Leitungen des Kabelbaumes wird als aktuelle Prüfleitung gewählt. An den verbleibenden Leitungen des Kabelbaumes wird ein elektrisches Referenzpotential angelegt. An der Prüfleitung wird ein elektrisches Prüfsignal angelegt. Anhand des elektrischen Potentials der Elektrode wird eine Kenngröße ermittelt. Anschließend wird eine Entscheidung getroffen. Dabei wird entschieden, dass die Prüfleitung im Prüfabschnitt liegt, wenn die Kenngröße ein Testkriterium erfüllt. Alternativ wird entschieden, dass die Prüfleitung nicht im Prüfabschnitt liegt, wenn die Kenngröße das Testkriterium nicht erfüllt.

Das Verfahren ist derart ausgelegt, dass Kabelbäume überprüfbar sind, die mindestens zwei, insbesondere mehrere Zig, zum Beispiel dreißig, vierzig, fünfzig und mehr, mehr als einhundert oder auch mehrere Hundert Leitungen enthalten. Der Kabelbaum kann dabei auch ein Teil-Kabelbaum sein, also ein struktureller Teil eines größeren Kabelbaumes. Die Überprüfung erstreckt sich dann auf das Vorhandensein aller Leitungen im Prüfabschnitt, also an einer Messstelle, in dem Teil-Kabelbaum als strukturellem Teil des größeren Kabelbaumes. Der zu prüfender Kabelbaum ist insbesondere ein solcher, der nur an einer Seite bzw. an einem Ende - d.h. an jedem einen Ende mindestens einer oder aller Leitungen - Anschlusselemente, z.B. Steckverbinder, Kabelschuhe etc., aufweist, die andere Seite des Kabelbaumes (bzw. der Leitungen) ist zumindest teilweise aus losen Kabelenden gebildet. Dort sind die Leitungen also nicht mit Steckverbindern etc. versehen

Insbesondere weist jede Leitung ein erstes und ein zweites Ende auf. Jede Leitung ist dann eine Einzelleitung, welche zwischen erstem und zweitem Ende durchverbunden ist, keine elektrischen Abzweigungen oder Kurzschlüsse zu anderen Leitungen oder sonstigen Elementen aufweist. Die Leitung kann insbesondere auch eine Schirmleitung für eine oder mehrere andere Leitungen sein, die dann geschirmte Leitungen innerhalb des Kabelbaumes darstellen.

Insbesondere erfolgt die Einspeisung des Prüfsignals und das Anlegen des Referenzpotentials an jeweiligen ersten Enden der jeweiligen Leitungen, die zweiten Enden aller Leitungen können dann insbesondere leerlaufend gehalten werden, das heißt keinen elektrischen Kontakt zu anderen Leitern, Potentialen usw. haben.

"Leerlaufend" bedeutet insbesondere, dass das Potential der Leitung nicht durch einen elektrischen Anschluss vorgegeben ist, sondern sich im elektromagnetischen Feld frei einstellen kann. Dies stellt eine besonders einfache Verfahrensvariante dar, da somit die zweiten Leitungsenden nicht gehandhabt werden müssen.

Insbesondere werden nur diejenigen Leitungen (nacheinander) mit dem Prüfsignal beaufschlagt, von denen erwartet wird, dass diese im Prüfabschnitt liegen. Andere Leitungen werden nicht mit dem Prüfsignal angesteuert, da bezüglich dieser ohnehin eine "Nein"-Entscheidung zu erwarten ist. Dies spart Prüfzeit für den (Teil-)Kabelbaum. Dies stellt den Normalfall dar. Im Einzelfall können aber auch alle Leitungen angesteuert werden, um eine fehlerhafte Verlegung im Prüfabschnitt zu erkennen.

Insbesondere wird nur genau eine der Leitungen als aktuelle Prüfleitung gewählt. Insbesondere sind alle elektrischen Referenzpotentiale für alle restlichen Leitungen gleich und/oder insbesondere konstant über der Zeit. Insbesondere ist das Prüfsignal ein zeitveränderliches Signal. Dessen Amplitude liegt insbesondere im Bereich von +- 3 Volt bis +- 24 Volt, insbesondere zwischen +- 5 Volt und +- 10 Volt. Bei einem periodischen Prüfsignal liegt dessen Frequenz vorzugsweise im Bereich größer 100 Hertz, vorzugsweise größer 300, größer 400 oder insbesondere bei 500 Hertz. Dies sind insbesondere Zirka-Angaben, die z.B. im einstelligen Prozentbereich bzw. um einige Hertz variieren können.

Insbesondere ist das Prüfsignal ein Potential- bzw. Spannungsverlauf über der Zeit. Insbesondere wird als Referenzpotential ein Massepotential oder Nullpotential oder Erdpotential, vor allem der Messvorrichtung, verwendet. Für das "Referenzpotential" wird hier teils auch vereinfachend der Begriff "Erde" bzw. "geerdet" usw. verwendet.

Gemäß dem Verfahren erfolgt eine Überprüfung der aktuell gewählten Prüfleitung, ob diese im Prüfabschnitt liegt oder nicht. Gemäß dem Verfahren werden insbesondere nacheinander mehrere verschiedene, insbesondere alle Leitungen als Prüfleitungen gewählt. So lässt sich für den gesamten Kabelbaum feststellen welche der Leitungen durch den Prüfabschnitt führen und welche nicht.

An einem Kabelbaum, insbesondere einem solchen mit Verzweigungen, können insbesondere nacheinander mehrere Prüfabschnitte gewählt werden und eine jeweilige Anzahl von Leitungen gemäß dem Verfahren auf Ihr Vorhandensein im jeweiligen Prüfabschnitt überprüft werden.

Gemäß dem Verfahren ist es möglich, berührungslos und ohne großen Handhabungsaufwand zu überprüfen, welche Leitungen wo im Kabelbaum verlaufen.

Für das Verfahren wird angenommen, dass Kapazitäten, die die Elektrode mit außerhalb des Prüfabschnitt liegenden Leitungen bildet, stets kleiner sind als die willentlich mit den Leitungen im Prüfabschnitt gebildeten Kapazitäten. Solche "parasitären" Kapazitäten haben dann messtechnisch keinen merklichen Einfluss auf das Potential an der Elektrode. So werden faktisch nur Leitungen innerhalb des Prüfabschnitts ausgewertet.

Das Verfahren benötigt wegen seines kapazitiven Charakters keine Durchströmung der Leitung, sondern nur das Anlegen eines elektrischen Potentials bzw. einer Spannung an der Leitung. Somit muss kein Durchgangsstrom durch die Leitung fließen können.

Die Erfindung ermöglicht es, eine berührungslose Leitungserkennung bei Kabelbäumen zu etablieren. Es ergibt sich ein spezielles Messverfahren, das an einem "Leitungsbündel mit offenen Enden" erkennen kann, ob alle Leitungen in dem Bündel vorhanden sind und damit der Kabelbaum elektrisch komplett ist.

In einer bevorzugten Ausführungsform des Verfahrens ist eine der Leitungen im Kabelbaum eine Schirmleitung für mindestens eine weitere Leitung bzw. Ader des Kabelbaumes. Die Schirmleitung schirmt also mindestens eine der anderen Leitungen des Kabelbaumes ab und macht aus dieser eine geschirmte Leitung bzw. Ader. Gemäß dem Verfahren wird an die Schirmleitung ein Referenzpotential angelegt, wenn keine der geschirmten Leitungen bzw. Adern die aktuelle Prüfleitung ist. Alternativ wird die Schirmleitung leerlaufend gehalten, wenn eine der geschirmten Leitungen bzw. Adern die Prüfleitung ist.

Gemäß dieser Verfahrensvariante werden also auch Schirmungen (die Schirmleitung) von Leitungen auf Referenzpotential gelegt, wenn die Leitungen innerhalb des Schirms nicht zu vermessen sind. Die Schirmung bleibt dagegen unangeschlossen (leerlaufend), wenn eine der Leitungen innerhalb des Schirms gemessen werden soll.

In diesem Fall ergibt sich im Ersatzschaltbild der Anordnung eine Reihenschaltung aus zwei Kondensatoren: zwischen der zu messenden Leitungen und der Schirmung einerseits und der Schirmung und der Elektrode andererseits. Unter dieser Bedingung lassen sich auch Kabelbäume sicher durch das kapazitive Prüfverfahren überprüfen, wenn die Kabelbäume geschirmte Leitungen enthalten.

Befindet sich also ein ein- oder mehradriges Kabel (mehrere Leitungen bzw. Adern) mit Abschirmung (Schirmleitung) im Kabelbaum (z.B. ein Datenkabel für den CAN-Bus), dann lässt sich dieses Kabel dadurch identifizieren, dass der Kabelschirm (Schirmleitung) mit dem Anregungssignal (Prüfsignal) beaufschlagt wird. Dieses Kabel wirkt dann wie jede andere Ader im Kabelbaum. Sollen die einzelnen Adern in dem abgeschirmten Kabel identifiziert werden, dann darf der Schirm nicht auf Referenzpotential gelegt, insbesondere nicht geerdet werden. Die Adern des abgeschirmten Kabels werden der Reihe nach mit dem Prüfsignal beaufschlagt und erkannt.

In einer bevorzugten Ausführungsform des Verfahrens wird der Kondensator dadurch gebildet, dass die Elektrode das Leitungsbündel im Prüfabschnitt zumindest teilweise umgreift. Das Umgreifen oder Umringen erfolgt zumindest teilweise in einem Umfangsbereich des Prüfabschnitts, insbesondere wird der Prüfabschnitt vollständig umgriffen, insbesondere wird die Elektrode um den Prüfabschnitt gewickelt. Die Wickelung erfolgt insbesondere mit mehr als einer Windung, insbesondere mit einer einzigen Windung und zusätzlichem Überlapp, d.h. z.B. 1,05 / 1,1 / 1,2 oder 1,25 Windungen. Durch eine entsprechend platzierte bzw. gestaltete Elektrode entsteht ein Zylinderkondensator, obschon die innere Elektrode in Form der Leitung nicht unbedingt im Zentrum der äußeren Elektrode verläuft. So ist mit wenig Materialaufwand und auf geringem Raum eine Kapazität des Kondensators erreichbar, die zu guter Signalstärke des Potentials führt, welches das Messsignal darstellt. Der Zylinderkondensator hat sich als besonders vorteilhaft für die Durchführung des Verfahrens erwiesen. Für einen derartigen Zylinderkondensator ergibt sich der Vorteil, dass eine durch diesen führende Prüfleitung einen deutlich anderen Potentiallauf an der äußeren Elektrode bewirkt als eine Leitung, die außerhalb der Zylinderelektrode verläuft. So kann besonders gut unterschieden werden, ob ein Prüfsignal innerhalb des Zylinderkondensators liegt oder nicht.

Alternativ ist es auch denkbar, beliebig geformte Kondensatoren zu bilden, z.B. den Kondensator dadurch zu bilden, dass die Elektrode als Platte neben das Leitungsbündel gelegt wird, z.B. parallel zu diesem. Jegliche andere kapazitive Anordnung zwischen Elektrode und Leitungen des Leitungsbündels ist ebenfalls denkbar.

In einer bevorzugten Ausführungsform wird an der Elektrode und damit an dem Kondensator, welcher durch die Elektrode und die Leitung gebildet ist, eine elektrische Schirmelektrode angeordnet. Die Anordnung erfolgt derart, dass die Schirmelektrode die Elektrode zu einem Außenraum hin zumindest teilweise umgibt. So wird die Einwirkung elektromagnetischer Störungen aus der Umgebung des Kondensators auf diesen Kondensator reduziert. Insbesondere umgibt bzw. umringt die Schirmelektrode den Kondensator teilweise, insbesondere in einer Umfangsrichtung um die Leitung vollständig ringförmig. Die Schirmelektrode wird insbesondere ebenfalls auf Referenzpotential gelegt. Die Schirmelektrode wird insbesondere parallel zur Elektrode angeordnet. Die Messung bzw. Messungsqualität am Kondensator bzw. der Elektrode wird dadurch verbessert.

In einer bevorzugten Ausführungsform des Verfahrens wird die Kenngröße anhand einer Amplitude des Potentials der Elektrode ermittelt. Das Testkriterium enthält dann als zumindest Teilkriterium das Erreichen eines Grenzwertes der Kenngröße. Auch weitere Bearbeitungen bzw. Verarbeitungen der Amplitude zur Kenngröße sind hierbei möglich, wie beispielsweise eine Betragsbildung der Amplitude, eine Quadrierung der Amplitude, eine Mittelwertbildung usw. So können aussagekräftige Kenngrößen erzeugt werden.

In einer bevorzugten Ausführungsform des Verfahrens wird die Kenngröße anhand einer Störfilterung - insbesondere durch ein Filter - und/oder einer gleitenden Mittelwertbildung - insbesondere durch eine Mittelwerteinheit - ermittelt. Das Potential der Elektrode, insbesondere dessen Amplitude, wird also störgefiltert und/oder einer gleitenden Mittelwertbildung unterworfen, um zur Kenngröße zu führen. Insbesondere wird eine quadratische Mittelwertbildung oder auch weitere Maßnahmen, z.B. zur Rauschunterdrückung, an dem Potential der Elektrode oder den daraus abgeleiteten Größen durchgeführt, um schließlich die Kenngröße zu bilden.

In einer bevorzugten Ausführungsform wird die Kenngröße anhand eines Verlaufs des Potentials der Elektrode über der Zeit ermittelt. Das Testkriterium ist dann das Erreichen eines minimalen Korrelationsmaßes der Kenngröße mit dem Zeitverlauf des Prüfsignals. Mit anderen Worten wird die Korrelation zwischen dem zeitlichen Verlauf des Elektrodenpotentials oder einer daraus abgeleiteten Größer über der Zeit und dem Prüfsignal ermittelt. So wird verglichen, ob Zeitverläufe des Prüfsignals in der Kenngröße abgebildet sind. Auch dies lässt darauf schließen, ob das Prüfsignal im Kondensator wirkt, das heißt die das Prüfsignal führende Leitung Teil des Kondensators ist, also im Prüfabschnitt verläuft.

In einer bevorzugten Ausführungsform wird als Prüfsignal ein Dreiecksignal verwendet. Insbesondere ist dieses periodisch und/oder mittelwertfrei und/oder weist eine gleichschenklige Dreiecksform auf. In der Praxis hat sich ein derartiges Prüfsignal insbesondere im Zusammenhang mit einem Zylinderkondensator als besonders aussagekräftig erwiesen.

In einer bevorzugten Ausführungsform werden für die Überprüfung der aktuell gewählten Prüfleitung mehrere, insbesondere höchstens zehn Perioden eines periodischen Prüfsignals angelegt. Danach wird die Entscheidung getroffen, ob die Prüfleitung im Prüfabschnitt verläuft oder nicht. Anschließend wird das Prüfsignal pausiert, eine andere der Leitungen als Prüfleitung gewählt und dann das Prüfsignal dort erneut angelegt. Insbesondere werden höchstens fünf oder höchstens drei Perioden des periodischen Prüfsignals angelegt, bevor die Entscheidung getroffen und pausiert wird. Insbesondere erfolgt also nach kurzer Prüfung die Umschaltung auf die nächste Leitung. Insbesondere wird während der Anregung durch das Prüfsignal der Signalverlauf an der Elektrode des Potentials gespeichert und dann ausgewertet. Ein Anschwingen und Ausschwingen des Potentials am Kondensator wird hierbei berücksichtigt. Vorzugsweise wird das Prüfsignal eine Signalperiode lang pausiert. Das Pausieren erfolgt z.B. durch Multiplikation eines Grundsignals (insbesondere ein Signal eines Dreieckgenerators) mit einer Fensterfunktion. In der Pause erfolgt die Aderumschaltung, also der Wechsel der Prüfleitung. Das PulsPausen-Verhältnis wird also insbesondere so gewählt, dass 3 Perioden des Anregungssignals auf die Ader geschaltet werden und eine Umschaltpause von einer Signalperiode entsteht. Dieses Verhältnis (3 zu 1 / Signalperioden zu Pause) hat sich in der Praxis für eine sichere Adererkennung bewährt.

In einer bevorzugten Ausführungsform werden das Prüfsignal und das Referenzpotential über einen Vorwiderstand (zwischen einer Prüfsignalquelle und der zu prüfenden Leitung) an der jeweiligen Leitung angelegt, und ein elektrisch zugänglicher Anschluss der Leitung wird auf einem Ablageelement abgelegt, wobei das Ablageelement elektrisch isoliert oder über einen Trennwiderstand mit dem Referenzpotential verbunden wird. So können gegebenenfalls auch Kurzschlüsse zwischen Leitungen und Kurzschlüsse von Leitungen mit dem Ablageelement messtechnisch erkannt werden. Jedenfalls ist so stets ein Messsignal in Form des Potentials vorhanden, das auswertbar ist.

Der Vorwiderstand zwischen einer Signalquelle und der Prüfleitung dient zur Strombegrenzung des Signalgenerators im Kurzschlussfall. Der Kurzschluss eines offenen Aderendes gegen Masse muss vermieden werden. Offene Aderenden sollten sich auf einer isolierenden Unterlage (Ablageelement) befinden. Wenn sich mehrere offene Aderenden auf einer isolierenden Unterlage befinden, können sich die signalführende Ader (Prüfsignal) und eine oder mehrere andere Leitungen bzw. Adern gegenseitig berühren und so einen Kurzschluss gegen Masse herbeiführen.

Um das zu vermeiden, wird ein Vorwiderstand zwischen den Potentialanschluss für das Referenzpotential und die restlichen Leitungen geschaltet.

Der Kurzschluss eines offenen Endes der angesteuerten Ader direkt nach Masse muss verhindert werden. Das offene Aderende muss sich daher auf einer isolierenden Unterlage befinden oder der Massepunkt muss über einen Widerstand angehoben werden. Der Strom durch die Prüfleitung fließt durch die beiden Vorwiderstände an der Prüfleitung und der Unterlage. und die Ader. Die gesamte Spannung des Testsignals fällt über den Widerständen ab. Durch die Spannung über der Ader entsteht ein Sensorsignal zur Identifizierung der Ader. Wenn die Gefahr besteht, dass offene Aderenden einen Kurzschluss gegen Masse bilden können, dann muss dieser Kurzschluss über den Widerstand an der Unterlage führen.

Das offene Ende der angesteuerten Ader kann auch einen Kurzschluss zu einer anderen Ader erzeugen. Da diese Ader geerdet ist, fließt über die Widerstände an der Signalquelle und am Potentialanschluss ebenfalls der Strom nach Masse. Die gesamte Spannung des Testsignals fällt über den Widerständen ab. Durch die Spannung über der Ader entsteht ein Sensorsignal zur Identifizierung der Ader.

Die Aufgabe der Erfindung wird auch gelöst durch eine Messvorrichtung gemäß Patentanspruch 10. Die Messvorrichtung und zumindest ein Teil deren Ausführungsformen sowie die jeweiligen Vorteile wurden sinngemäß bereits im Zusammenhang mit dem erfindungsgemäßen Verfahren erläutert.

Die Messvorrichtung dient zum Überprüfen des oben genannten Kabelbaumes. Die Messvorrichtung weist eine Mehrzahl von Kupplungselementen auf. Jedes Kupplungselement dient zur jeweiligen elektrischen Kontaktierung einer jeweiligen der Leitungen. Über die Kupplungselemente werden also das Prüfsignal und die Referenzpotentiale an die Leitungen angelegt. Die Kupplungselemente können die Leitungen bzw. deren Anschlusselemente wie Stecker oder Buchsen direkt kontaktieren. In der Regel übernimmt dies jedoch ein speziell dafür konzipierter Prüftisch mit Prüfmodulen. Das Kupplungselement dient dann der Verbindung mit einem Anschlusselement des Prüftisches, in der Regel einer Klemmleiste. Innerhalb des Prüftisches ist die Klemmleiste dann mit den einzelnen Kontakten (Prüfmodul) verschaltet, die der eigentlichen Kontaktierung der Leitung dienen. Die Messvorrichtung enthält eine Elektrode. Die Elektrode ist an einem Prüfabschnitt des Kabelbaumes anordenbar, wobei die Elektrode mit jeder der Leitungen des Leitungsbündels im Prüfabschnitt einen jeweiligen Kondensator bildet. Der Prüfabschnitt des Kabelbaumes ist hierbei ein Leitungsbündel mit wenigstens einer der Leitungen des Kabelbaumes.

Die Messvorrichtung enthält eine Steuer- und Auswerteeinheit. Diese ist mit den Kupplungselementen verschaltet, um wahlweise ein elektrisches Prüfsignal oder ein elektrisches Referenzpotential am Kupplungselement bereitzustellen. Die Steuer- und Auswerteeinheit ist auch mit der Elektrode verschaltet, um das dort vorhandene Potential zu erfassen und weiterzuverarbeiten, und ist dazu ausgebildet, die Steuer- und Auswerteschritte des erfindungsgemäßen Verfahrens durchzuführen. Diese sind im Wesentlichen das Empfangen und Verarbeiten des Potentials der Elektrode und das Treffen der Entscheidung einschließlich Ermittlung der Kenngröße und Prüfung gegenüber dem Testkriterium. Gegebenenfalls auch die Auswahl der Prüfleitung und/oder das Anlegen des Prüfsignals oder des Referenzpotentials. Die Messvorrichtung weist eine Ausgangsschnittstelle auf. Die Ausgangsschnittstelle dient zur Ausgabe der gemäß dem Verfahren getroffenen Entscheidung.

Die Messvorrichtung ist so dimensioniert, dass genügend Kupplungselemente zur Verfügung stehen, um eine maximal zu erwartende bzw. dimensionierte Anzahl von Leitungen in zu erwartenden Kabelbäumen, welche zu prüfen sind gleichzeitig zu kontaktieren. In der Messvorrichtung bzw. dem oben genannten Prüftisch oder Prüfmodul müssen keine Anschlussmöglichkeiten für eine jeweilige zweite Kontaktierung der Leitungen, z.B. an deren zweiten Enden, vorgesehen sein, da diese wie oben erläutert leerlaufen können, das heißt im Verfahren nicht weiter angeschlossen werden müssen. Die Messvorrichtung muss also nicht für die Durchgangsmessung von Leitungen ausgebildet sein. Somit muss diese nur die Hälfte von Anschlüssen gegenüber Durchgangsmessvorrichtungen aufweisen, da dort für jede Messung jede Leitung an Ihren beiden Enden kontaktiert werden muss. Wie oben erläutert, wäre eine Einzelkontaktierung für offene Leitungsenden sehr aufwändig.

Insgesamt ergibt sich eine Messvorrichtung mit deutlich reduzierten Anschlussaufwand für einen zu prüfenden Kabelbaum.

In einer bevorzugten Ausführungsform ist die Messvorrichtung für Kabelbäume ausgelegt, bei denen mindestens eine der Leitungen zumindest einseitig (an einem der Leitungsenden) ein Verbindungselement zur elektrischen Kontaktierung der jeweiligen Leitung aufweist. Das Kupplungselement der Messvorrichtung (oder der Prüftisch bzw. das Prüfmodul, wie oben erläutert) weist dann ein Kontaktierungsmittel zur elektrischen Kontaktierung des Verbindungselements auf. Ist an einem Kabelbaum also beispielsweise ein bestimmter Stecker vorgesehen, in welchem eine Zahl der Leitungen angeschlossen sind, weist die Messvorrichtung eine entsprechend passende Buchse zur Aufnahme des Steckers auf, wobei die Kupplungselemente als Kontaktierungsmittel in der Buchse enthalten sind. Stecker und Buchse können auch vertauscht sein. So können entsprechend vorkonfektionierte Kabelbäume besonderes einfach mit der Messvorrichtung zum Anlegen des Prüfsignals und der Referenzpotentiale verbunden werden.

In einer bevorzugten Ausführungsform ist die Elektrode zumindest Teilweise um den Prüfabschnitt des Kabelbaumes schlingbar. Die Elektrode ist also insbesondere biegsam bzw. flexibel bzw. verformbar und dadurch um den Prüfabschnitt herum schlingbar bzw. wickelbar. Insbesondere ist diese so dimensioniert, dass sie die zu erwartenden Kabelbäume im Prüfabschnitt vollständig umschließen kann, mit mindestens einer Windung oder mehr. Insbesondere ist die Elektrode oder enthält diese ein flexibles elektrisch leitendes Geflecht oder Gewebe oder ähnliches, insbesondere ist dieses metallisch, z.B. aus Kupfer.

In einer bevorzugten Ausführungsform enthält die Messvorrichtung eine Manschette. Die Elektrode ist in der Manschette aufgenommen. Zum Handhaben der Elektrode muss also lediglich die Manschette gehandhabt werden. Die Manschette ist insbesondere zumindest teilweise um den Prüfabschnitt schlingbar, insbesondere mit mehr als einer Windung um den Prüfabschnitt wickelbar. Insbesondere weist die Manschette dabei Befestigungsmittel, wie zum Beispiel Klettverschlüsse auf, um diese sicher am Prüfabschnitt zu fixieren.

In einer bevorzugten Variante der Ausführungsform enthält die Manschette die oben genannte Schirmelektrode. Die Schirmelektrode ist in der bzw. durch die Manschette von der Elektrode elektrisch isoliert. In einem bestimmungsgemäßen Montagezustand der Manschette am Prüfabschnitt umgibt die Schirmelektrode zumindest teilweise die Elektrode bzw. den aus Leitung und Elektrode gebildeten Kondensator. So erfolgt eine Schirmung des Kondensators und verbesserte Messeigenschaften.

In einer bevorzugten Ausführungsform enthält die Messvorrichtung eine Signalquelle zur Bereitstellung des Prüfsignals und einen Potentialanschluss zur Bereitstellung des Referenzpotentials. Die Messvorrichtung enthält jeweilige Schaltelemente für jedes der Kupplungselemente, jedes der Schaltelemente verbindet in einer ersten Schaltstellung das Kupplungselement mit der Signalquelle und in einer zweiten Schaltstellung das Kupplungselement mit dem Potentialanschluss. Das Schaltelement schaltet also das Kupplungselement zwischen Prüfsignal und Referenzpotential um. Durch Betätigung der Schaltelemente kann so ohne physikalisches Umklemmen der Leitungen zwischen verschiedenen Kupplungselementen das Prüfsignal an beliebige Leitungen angelegt werden und die Referenzpotentiale an die entsprechend anderen Leitungen angelegt werden. Insbesondere ist das Schaltelement ein Halbschaltelement. Insbesondere ist dieses bezüglich seines Schaltsignals galvanisch und/oder optisch schaltbar. So können auch Störeinflüsse bezüglich der Schaltelemente in der Messvorrichtung eliminiert werden.

Gemäß der Erfindung ist zumindest ein Teil der Elektrode als Mehrfachstruktur ausgebildet. Die Mehrfachstruktur weist mindestens zwei Messkammern auf. In jede der Messkammern ist mindestens eine der Leitungen des Leitungsbündels einlegbar. Eine Elektrode kann eine einzelne Messkammer zum Einlegen des gesamten Leitungsbündels darstellen. Bei einem Leitungsbündel mit einer Vielzahl von Leitungen kann es - im Querschnitt betrachtet - innerhalb einer Messkammer vorkommen, dass eine mit dem Prüfsignal zu vermessende Leitung von so vielen anderen Leitungen auf Referenzpotenzial umgeben ist, dass diese die betreffende Leitung zur Elektrode hin abschirmen. Durch die Aufteilung des Leitungsbündels auf "Teilbündel" mit jeweils mindestens einer Leitung und die Aufteilung der Elektrode in mindestens zwei Messkammern für jeweils mindestens eines der Teilbündel gemäß dieser Ausführungsform können derartige Effekte reduziert oder gänzlich vermieden werden.

"Einlegbar" ist dabei so zu verstehen, dass die entsprechend eingelegte Leitung durch die Messkammer hindurch geführt ist oder in dieser endet. Insbesondere wird die Elektrode also aus mindestens zwei verketteten Einzelkammersensoren in Form der Messkammern gebildet.

In einer bevorzugten Variante dieser Ausführungsform ist die Mehrfachstruktur als einseitig offene Kammstruktur ausgebildet, wobei die Messkammern als - insbesondere U- oder V- förmige - Messkammern zwischen jeweils zwei der Kammzähne bzw. -zinken gebildet sind. Insbesondere ist die Mehrfachstruktur bzw. Elektrode nach Art eines Rippen-Kühlkörpers mit parallelen Rippen bzw. als Kamm- oder Rechenstruktur ausgebildet. Eine derartige Kamm-oder Rechenstruktur bildet im Querschnitt insbesondere einseitig offene Messkammern aus, in die jeweils einzelne oder vergleichsweise wenige Leitungen (die o.g. Teilbündel) des Leitungsbündels besonders leicht einlegbar sind.

In einer bevorzugten Variante dieser Ausführungsform weist die Mehrfachstruktur mindestens zwei voneinander getrennte Elektrodenabschnitte auf, wobei jeder der Elektrodenabschnitte mindestens eine der Messkammern bildet.

Die Elektrode kann als einstückige Struktur ausgebildet sein. Dieser Struktur ist dann insbesondere eine einzige Stromversorgung und/oder Auswerteelektronik zugeordnet. Die Elektrode gemäß der vorliegenden Ausführungsform ist dagegen in mehrere Teile aufgeteilt. Insbesondere kann dabei außerdem jeder Teil als Einzelelektrode mit eigener Stromversorgung und/oder Auswerteelektronik und/oder Messverstärker ausgeführt sein kann. Insofern ergibt sich auch für die Steuer- und Auswerteeinheit insbesondere eine verteilte Struktur, wobei insbesondere die einzelnen Elektrodenabschnitte mit eigener Auswerteelektronik etc. über eine Datenbus- und/oder Energieversorgungsstruktur mit einer Zentraleinheit der Steuer und Auswerteeinheit verbunden sind.

Auch für die oben genannten Ausführungsformen mit Elektrode in Mehrfachstruktur sind wieder entsprechende Ausführungsformen mit Schirmelektroden, wie sie bereits oben erläutert wurden, denkbar, welche die Elektrode bzw. Elektrodenteile zu einem Außenraum hin oder gegeneinander abschirmen. Insbesondere kann jedem Elektrodenabschnitt eine eigene - insbesondere U-förmige oder V-förmige - Schirmelektrode zugeordnet sein.

Die Erfindung beruht auf folgenden Erkenntnissen bzw. Überlegungen, wobei in diesem Zusammenhang als "Erfindung" auch Ausführungsformen der Erfindung genannt sind, die Kombinationen der oben genannten Ausführungsformen entsprechen und/oder gegebenenfalls auch bisher nicht erwähnte Ausführungsformen einschließen.

Die Erfindung besteht prinzipiell in einem Messverfahren, das nur eine einseitige Kontaktierung der Adern benötigt und das die richtige Lage der Ader im Kabelbaum bzw. seinen Zweigen erkennen kann.

Bei der Fertigung von komplexen Kabelbäumen entstehen auch Teil-Kabelbäume, die in einen übergeordneten Kabelbaum eingelegt werden. An diesem Einlegepunkt gibt es ein Leitungsbündel mit offenen Enden, d.h. die Leitungen enden nicht in einem Stecker sondern sind offen (lose). Mit anderen Worten weisen solche Teil-Kabelbäume also nur an einem Ende Steckverbinder bzw. Anschlusselemente auf, das andere Ende ist aus losen Kabelenden gebildet.

Bei solchen Teil-Kabelbäumen können die üblichen elektrischen Testsysteme nur schwerlich verwendet werden, die über spezielle Gehäuseaufnahmen die einzelnen Pins der Kabelbaum-Stecker kontaktieren, da die einen Kabelenden noch nicht mit Steckern versehen sind. Hier ist eine Einzelkontaktierung zum Prüftisch zwar möglich, aber außerordentlich aufwändig.

Die Erfindung beruht auf der Idee, eine berührungslose Leitungserkennung bei Kabelbäumen zu etablieren. Die Idee ist weiterhin, ein spezielles Messverfahren zu konzipieren, das an einem "Leitungsbündel mit offenen Enden" erkennen kann, ob alle Leitungen in dem Bündel vorhanden sind und damit der Kabelbaum elektrisch komplett ist.

Die Erfindung beruht auf der Idee, den (Teil-)Kabelbaum über die vorhandenen Kabelbaum-Stecker an ein elektrisches Testsystem anzuschließen. Beim Einlegepunkt, d.h. dem Leitungsbündel mit offenem Ende, kommt das erfindungsgemäße Messverfahren zur berührungslosen Leitungserkennung zum Einsatz. Dabei speist das elektrische Testsystem auf der Kabelbaum-Steckerseite nacheinander zu jeder elektrischen Verbindung einen Spannungsimpuls (Prüfsignal) ein. Das Messverfahren muss jetzt berührungslos jeden dieser Spannungsimpulse auf der anderen Leitungsseite, d.h. beim Einlegepunkt, erkennen und eine entsprechende Meldung (Entscheidung) absetzen. Das Messverfahren muss dabei weder die einzelne Leitung identifizieren, die diesen Spannungsimpuls "trägt", noch einen Leitungsbruch erkennen.

Die Erfindung bewegt sich im Rahmen folgender Randbedingungen:
Die Erfindung ist in Bezug auf einen Kabelbaum ausgelegt auf ein Leitungsbündel am Einlegepunkt mit mehreren Hundert, z.B. 300 oder mehr elektrischen Verbindungen und einer Bündeldicke von z.B. 8 cm und mehr Durchmesser. Verschiedenen Leitungstypen, d.h. Einzelleitungen, verdrillte Leitungen (insbesondere 2- bis 4-fach), Mantelleitungen (mehrere Andern) mit und ohne Schirm sollen vermessbar sein. Leitungen in verschiedenen Längen (insbesondere 0,5 bis 15 m) und Querschnitten (insbesondere 0,15 - 10 mm²) sollen erfassbar sein. Die offenen Leitungsenden sind im Normalfall abisoliert oder mit unisolierten Kontakten versehen, d.h. ein "Kurzschluss" zwischen offenen Leitungsenden ist möglich.

In Bezug auf die Anordnung der Messeinrichtung am Einlegepunkt ist die Anordnung der Messeinrichtung und des Leitungsbündels frei, z.B. sind Bündel mit Schleife zulässig. Eine einfache Handhabung des Leitungsbündels ist nötig, d.h. keine aufwändigen Sortierungen bzw. keine Handhabung von Einzelleitungen soll nötig sein.

Hinsichtlich eines Spannungsimpulses im Prüfsignal soll eine ungefährliche Spannungshöhe, z.B. kleiner oder gleich 48 V Gleichspannung oder kleiner oder gleich 20 V Wechselspannung, realisiert werden, ansonsten eine frei wählbare Impuls-Form (im Rahmen der Zeitanforderungen).

Hinsichtlich der Zeitanforderungen für das Messverfahren gilt, dass für die Dauer vom Start des Spannungsimpulses (Anlegen des Prüfsignals) bis zum Abschluss der Rückmeldung (je Leitung) - d.h. der Festlegung der Entscheidung - ein Ziel von 0,1 sec oder schneller angestrebt ist. Damit ergeben sich ca. 30 Sekunden Messzeit bei 300 Verbindungen.

Für den berührungslosen Test auf das Vorhandensein einer Ader (Leitung) in einem Kabelbaum wird ein kapazitives Messverfahren vorgeschlagen. Die Kapazität wird durch eine Ader des Kabelbaums und eine umhüllende Elektrode aus Kupfergewebe gebildet. Damit liegt das Prinzip eines Zylinderkondensators vor, auch wenn sich die innere Elektrode (Ader) nicht symmetrisch in der Mitte befindet. Zur einfachen Handhabung wird die umhüllende Elektrode als Manschette ausgebildet. Eine zweite umhüllende Elektrode (Schirmelektrode) ist als Abschirmung gegen Störungen geerdet. Diese Einheit wird auch als "Sensormanschette" bezeichnet.

Um den Hauptzweig des (Teil-)Kabelbaums wird die oben beschriebene Sensormanschette gelegt. Die Kupfergeflechte sind in eine Tasche, z.B. aus Baumwollstoff, (Manschette) eingenäht. Der Kabelbaum wird in die offene Manschette eingelegt, die dann mit einem Klettverschluss verschlossen wird. Um ein Übersprechen von der mit dem Testsignal angeregten Ader auf andere Adern und das Einkoppeln von Störungen insbesondere 50-Hz-Brumm zu vermeiden, sind alle Adern, bis auf die zu untersuchende Ader, zu erden.

Gemäß der Erfindung ergibt sich ein berührungsloser Test auf das Vorhandensein einer Ader in einem Kabelbaum. Mit der vorgeschlagenen digitalen Signalverarbeitung lässt sich aus dem Signal der Sensormanschette eindeutig eine Ader, die mit dem dreieckförmigen Testsignal angeregt wird und durch diese Manschette verläuft, erkennen. Voraussetzung dafür ist, dass alle anderen Adern im Kabelbaum geerdet sind. Wenn sich ein mehradriges, abgeschirmtes Kabel im Kabelbaum befindet, kann auch dieses durch die berührungslose Adererkennung getestet und erkannt werden. Ein mehradriges Kabel mit Abschirmung im Kabelbaum kann nur erkannt werden, wenn es durch die Sensormanschette verläuft. Dabei kann durch die Anregung des Schirms mit dem Testsignal das abgeschirmte Kabel als Ganzes identifiziert werden.

Wenn der Schirm nicht geerdet wird, lassen sich auch die einzelnen Adern des abgeschirmten Kabels identifizieren. Für den Test einer "normalen Ader" im Kabelbaum muss der Schirm des abgeschirmten Kabels genauso wie alle anderen Adern, die gerade nicht getestet werden, geerdet werden.

Die Schwellenwerte zur Entscheidungsbildung können in den Messungen fest vorgegeben und manuell auf den Testaufbau abgestimmt werden. Bei einer Messung an einer beliebigen Position im Kabelbaum und an anderen Kabelbäumen kann jedoch der zu erwartende Mittelwert und damit der Schwellenwert a priori nicht exakt festgelegt werden. Da eine Messung nur wenige Millisekunden dauert und damit auch die Dauer aller Messungen eines Kabelbaums keine lange Zeit beansprucht, wird für jeden Kabelbaumtyp eine charakterisierende Messung für die Bestimmung der Schwellenwerte durchgeführt. Dies könnte zum Beispiel durch die Bildung des quadratischen Mittels aller Mittelwerte der n Adern im Kabelbaum erfolgen. Alternativ bietet sich auch ein Clustering-Algorithmus an, wie etwa k-means (mit k = 2). Ein k-means-Algorithmus ist z.B. aus der Quelle: https://de.wikipedia.org/wiki/K-Means-Algorithmus bekannt.

In einer bevorzugten Ausführungsform wird die Ausgabe des Testsignals und die Aufnahme des Sensorsignals über eine interne Soundkarte, Steckkarte, USB-Modul eines Notebooks / PCs, insbesondere mit einer Samplingfrequenz von 48 kHz, durchgeführt. Es ist davon auszugehen, dass auch niedrigere Samplingraten zu guten Ergebnissen führen. Als Testsignal wird insbesondere eine Dreieckfunktion mit 500 Hz gewählt. Für die digitale Erfassung des Sensorsignals ist insbesondere eine Abtastfrequenz zwischen 5 kHz und 10 kHz ausreichend.

Bei der Ermittlung der Kenngröße kann z.B. ein quadratischer Mittelwert verwendet werden, wie er aus der Quelle: https://de.wikipedia.org/wiki/Quadratisches_Mittel bekannt ist.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen in einer schematischen Prinzipskizze:
- Figur 1: einen Kabelstrang in einer Messvorrichtung,
- Figur 2: ein Blockschaltbild eines Teils der Messvorrichtung,
- Figur 3: Zeitverläufe verschiedener Signale für eine a) detektierte und b) nicht detektierte Leitung,
- Figur 4: eine Manschette an einem Kabelbaum,
- Figur 5: eine symbolischen Querschnitt durch Manschette und Kabelbaum,
- Figur 6: Kabelstrang und Messvorrichtung mit Umschalteinheit,
- Figur 7: eine alternative Messvorrichtung mit Kabelstrang und Fehlerfällen,
- Figur 8: eine alternative Elektrode in Kammstruktur,
- Figur 9: eine Variante der Kammstruktur mit getrennten Elektrodenabschnitten a) im Querschnitt und b) in perspektivischer Ansicht.

Einander entsprechende oder gleiche Teile sind in den Figuren jeweils mit den gleichen Bezugszeichen versehen.

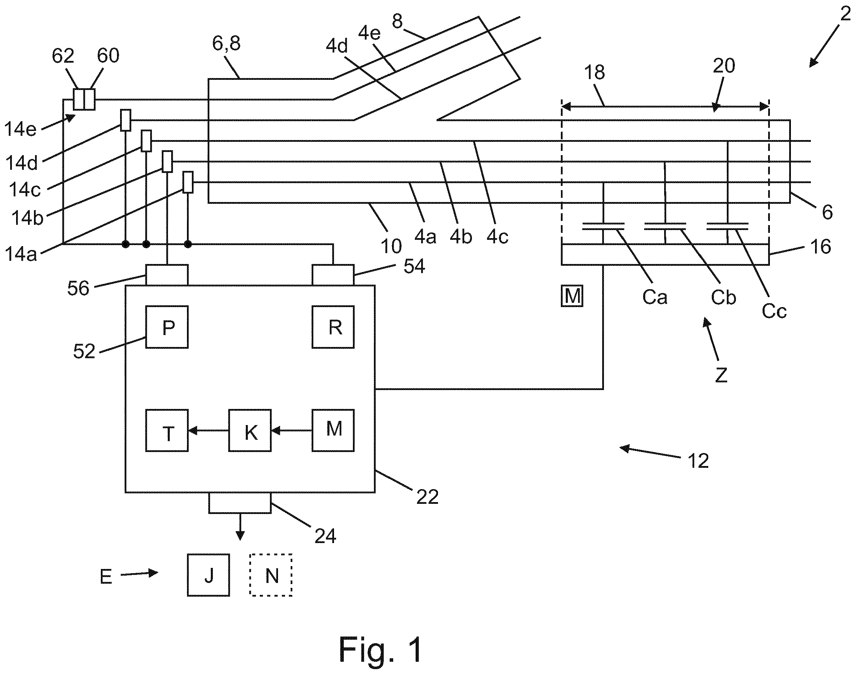

Figur 1 zeigt einen Kabelbaum 2, der mehrere, im Beispiel fünf Leitungen 4a - e enthält. Die Leitungen 4a - c verlaufen in einem Hauptstrang 6 und die Leitungen 4d,e verlaufen ein Stück weit mit im Hauptstrang 6, zweigen jedoch dann in den Abzweigstrang 8 ab. Der Kabelbaum 2 ist mit einer nicht näher beschriebenen Umhüllung 10 versehen, die einen direkten Zugang bzw. Blick auf die Leitungen 4a - e zumindest erschwert, wenn nicht verhindert.

Figur 1 zeigt auch eine Messvorrichtung 12, welche zum Überprüfen des Kabelbaumes 2 dient. Die Messvorrichtung 12 weist fünf Kupplungselemente 14 a - e auf, welche zur jeweiligen elektrischen Kontaktierung je einer der Leitungen 4a - e dienen. Die Verbindung ist nur symbolisch angedeutet und ist z.B. über Prüfmodule eines herkömmlichen Prüftisches bewerkstelligt. Die Kupplungselemente 14a-e sind dann z.B. Verbindungen mit einer Klemmleiste eines Prüftisches. Die Verbindung mit den Leitungen 4a-e erfolgt dann über Prüfmodule des Prüftisches. Die Messvorrichtung 12 enthält außerdem eine Elektrode 16, die an einem Prüfabschnitt 18 des Kabelbaumes 2 angeordnet ist. Der Prüfabschnitt 18 ist ein Leitungsbündel 20, welches im Beispiel die drei Leitungen 4a -c enthält. Die Anordnung ist derart gestaltet, dass die Elektrode 16 mit jeder der Leitungen 4a -c im Prüfabschnitt 18 einen jeweiligen Kondensator Ca-c bildet. Mit den Leitungen 4d,e weist die Elektrode keinen nennenswerten kapazitiven Effekt auf.

Die Messvorrichtung 12 enthält eine Steuer- und Auswerteeinheit 22, die mit den Kupplungselementen 14a-e verschaltet ist. Die Verschaltung ist derart, dass wahlweise ein elektrisches Prüfsignal P oder ein elektrisches Referenzpotential R am jeweiligen Kupplungselement 14a - e bereitgestellt wird. Im Beispiel sind die Leitungen 4a und c-d an das Referenzpotential R angeschlossen, die Leitung 4b an das Prüfsignal P. Die Steuer- und Auswerteeinheit 22 ist außerdem mit der Elektrode 16 verschaltet. Die Messvorrichtung 12 enthält außerdem eine Ausgangsschnittstelle 24 zur Ausgabe einer Entscheidung E. Die Steuer- und Auswerteeinheit 22 ist dazu ausgebildet, Steuer- und Auswertungsschritte eines im Folgenden erläuterten Verfahrens durchzuführen. Das Verfahren wird mit Hilfe der Messvorrichtung 12 durchgeführt.

Gemäß dem Verfahren, welches zum Überprüfen des Kabelbaumes 2 dient, wird zunächst der Prüfabschnitt 18 am Kabelbaum 2 gewählt, da dort auf das Vorhandensein von Leitungen 4a - c im Prüfabschnitt 18 bzw. dem dort vorhandenen Leitungsbündel 20 geprüft werden soll. Die Elektrode 16 wird am Prüfabschnitt 18 angeordnet, wobei sich die jeweiligen Kondensatoren Ca - Cc bilden. Dann wird eine der Leitungen des Kabelbaumes 2, im Beispiel die Leitung 4b, als aktuelle Prüfleitung gewählt. An den verbleibenden Leitungen 4a, c - e wird das elektrische Referenzpotential R angelegt. An der Prüfleitung 4b wird dann das Prüfsignal P angelegt. Wegen der kapazitiven Kopplung über den Kondensator Cb ergibt sich an der Elektrode 16 nun ein elektrisches Potential M in Form einer Messgröße. Anhand des Potentials M wird nun in der Steuer und Auswerteeinheit 22 eine Kenngröße K ermittelt und diese auf ein Testkriterium T hin überprüft. Erfüllt die Kenngröße K das Testkriterium T, wie im vorliegenden Fall gegeben, wird die Entscheidung E in der Form getroffen, dass diese ein Ja-Wert J ist, was bedeutet, dass die Kenngröße K das Testkriterium T erfüllt. In einem alternativen, hier nicht dargestellten Fall, wenn die Kenngröße K das Testkriterium T nicht erfüllen würde, würde als Entscheidung E ein Nein-Wert N ausgegeben, hier nur gestrichelt angedeutet. Der Nein-Wert N wird auch ausgegeben, wenn die Leitungen 4d,e wie beschrieben mit dem Prüfsignal P versorgt würden.

Fig. 1 zeigt für die Leitung 4e eine alternative Ausführungsform, bei welcher die Leitung 4e selbst ein Verbindungselement 60, hier an Ihrem Leitungsende, aufweist. Im Beispiel ist das Verbindungselement 60 Teil eines nicht weiter dargestellten mehrpoligen Steckverbinders. Das Kupplungselement 14e weist daher ein entsprechend passendes Kontaktierungsmittel 62 auf, hier eine entsprechendes Teil einer Buchse für den Stecker, um das Verbindungselement 60 elektrisch zu kontaktieren. Das Kontaktierungsmittel 62 ist dann z.B. Teil eines Prüftisches bzw.

Prüfmoduls. In der Regel sind an einem Ende des Kabelbaums 2 bereits ein oder mehrere Stecker oder Buchsen angebracht, die alle Leitungen 4 terminieren. Die Messvorrichtung 12 weist dann entsprechende Gegenstücke in Form von Buchsen oder Steckern mit den Kontaktierungsmitteln 62 aufweist, um die entsprechenden Verbindungselemente 60 und damit alle angeschlossenen Leitungen 4 sicher elektrisch zu kontaktieren. In dieser Hinsicht bildet das Messverfahren auch eine Überprüfung der sicheren Kontaktierung von Steckern oder Buchsen, das heißt Verbindungselementen 60 und eine Überprüfung der Verbindung zwischen den Verbindungselementen 60 und den jeweiligen Leitungen 4. Das andere Ende der Leitung 4e ist ein offenes Leitungsende ohne Anschlussmittel wie Stecker, Buchse etc. Fig. 1 zeigt in dieser Hinsicht also einen Kabelbaum - hier in Form eines TeilKabelbaums - der in einem herkömmlichen Testsystem nur aufwändig vermessbar ist, da ein Anschlussmittel am zweiten Ende zur Verbindung mit dem Testsystem fehlt und hier Einzelkontakte nötig wären.

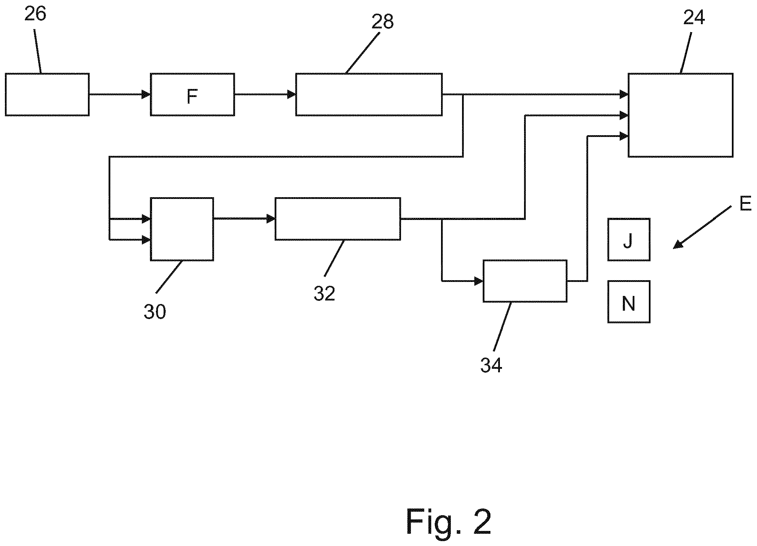

Figur 2 zeigt symbolisch die Ermittlung der Entscheidung E. Das Potential M an der Elektrode 16 wird zunächst von einer Abtasteinheit 26 abgetastet und mit einem Faktor F multipliziert. Der Faktor F bewirkt eine Verstärkungsanpassung an die aktuellen bzw. situationsabhängigen Mess- bzw. Verstärkungsverhältnisse, um gut auswertbare Signalpegel zu erhalten. In einem Filter 28, hier einem interpolierenden FIR-Filter, wird das Signal von einer 50Hz-Störung befreit. Über einen Multiplikator 30 erfolgt eine Quadrierung und über eine Mittelwerteinheit 32 die Bildung eines gleitenden Mittelwertes. Die Quadrierung und Berechnung des gleitenden Mittelwertes bewirkt, dass nur noch positive Signalpegel vorhanden sind. Dabei werden die signifikanten höheren Pegel stärker bewertet. Ein Schwellenwertschalter 34 liefert dann die Entscheidung E in Form des Ja-Signals J oder Nein-Signals N. Die Entscheidung E wird über die Ausgangsschnittstelle 24 so aufbereitet, dass sie einem übergeordneten Testsystem oder einer GUI (Graphic User Interface) zur Verfügung steht. Auch das entstörte Ausgangssignal des Filters 28 wird entsprechend ausgegeben. Die Ja-Entscheidung J bedeutet, dass die aktuell gewählte Testleitung 4b im Prüfabschnitt 18 erkannt wurde, die Nein-Entscheidung N bedeutet, dass die betreffende Leitung nicht erkannt wurde. Im Beispiel ist die Abtasteinheit 26 eine Soundkarte eines nicht dargestellten Notebooks, das Prüfsignal P ist ein Dreiecksignal.

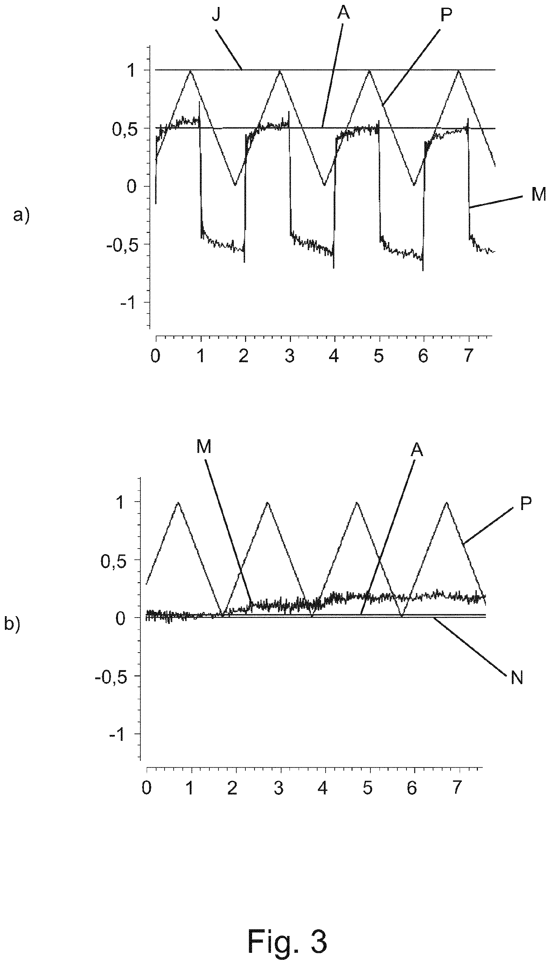

Figur 3a zeigt ein symbolisch die Ausgabe an einem Oszilloskop für eine Messung. Es liegen dabei alle Adern des Kabelbaumes bzw. Leitungen 4a, c - e auf Referenzpotential R hier Massepotential, bis auf die zu testende Leitung 4b. Diese Ader, die im Beispiel auch durch den Prüfabschnitt 18 verläuft, wird mit dem Testsignal bzw. Prüfsignal P, hier einem Dreieck von 500 Hertz - also 2 Millisekunden Periodendauer - beaufschlagt und von der Signalverarbeitung in der Steuer- und Auswerteeinheit 22 erkannt. Figur 3a zeigt symbolisch das Oszillogramm für das gefilterte Sensorsignal M am Ausgang des Filters 28 gemäß Figur 2. Durch den kapazitiv wirkenden Sensor bzw. die aus Elektrode 16 und Leitungsabschnitt der Leitung 4b im Prüfabschnitt 18 gebildete Kapazität Cb wird das anregende Dreiecksignal differenziert und damit zum symmetrischen Rechteck. Die Berechnung des gleitenden Mittelwertes aus dem Quadrat des Sensorsignals führt zu einem Signal A am Ausgang der Mittelwerteinheit 32. Das Signal J ist der Ausgang des Schwellenwertschalters 34 und zeigt die Entscheidung in Form des Ja-Wertes J, die Ader bzw. Leitung 4b wurde also im Kabelbaum bzw. Prüfabschnitt 18 erkannt. Der Schwellenwertschalter 34 steht also auf einer logischen 1. In Figur 3a sind nicht näher erläuterte Amplituden über der Zeit in Millisekunden aufgetragen. Durch die kapazitive Wirkung des Sensors ist das Sensorsignal das Differenzial des Anregungssignals. Ein Korrelationsmaß zwischen dem Sensorsignal M und dem Prüfsignal P ist ungleich Null, denn die Signale sind diesbezüglich miteinander korreliert. Das Korrelationsmaß liegt also oberhalb eines geeigneten Grenzwertes. So kann ebenfalls eine Ja-Entscheidung J erfolgen.

Figur 3b zeigt entsprechend Fig. 3a und bei gleichen Messbedingungen einen alternativen Fall. Hier wurde die Leitung 4b auf das Referenzpotential R gelegt, jedoch die Leitung 4d mit dem Prüfsignal P versorgt. Die mit dem Prüfsignal P versorgte Leitung 4d verläuft also nicht durch den Prüfabschnitt 18. Alle Leitungen 4a - c, 4e bis auf die zu testende Leitung 4d liegen also wieder auf Massepotential bzw. Referenzpotential R. Das Oszillogramm zeigt wieder das gefilterte Sensorsignal (Potential M) als Ausgang des Filters 28, das jetzt nicht mehr als differenziertes Dreiecksignal erkennbar ist. Ein Korrelationsmaß zwischen dem Sensorsignal M dem Prüfsignal P ist nahezu Null, liegt also unterhalb eines Grenzwertes. Dies führt zu einer Nein-Entscheidung N. Die Berechnung des gleitenden Mittelwertes aus dem Quadrat des Sensorsignals (Signal A, Ausgang der Mittelwerteinheit 32) führt zu einem nahe bei null liegenden Ergebnis, das zu einer Entscheidung führt, nämlich der Nein-Entscheidung N (Ausgang des Schwellenwertschalters 34). Dies bedeutet, dass die Ader bzw. Leitung 4d nicht im Prüfabschnitt 18 des Kabelbaumes 2 verläuft. Der Schwellenwertschalter 34 steht auf logisch null. Der Sensor liefert also kein erkennbares Signal, die angeregte Ader durchläuft nicht den Sensor. Das Mittelwertsignal A verläuft also nahe bei null. Das Mittelwertsignal A in Figur 3a,b entspricht dem Mittelwert des gleichgerichteten quadratischen Sensorsignals.

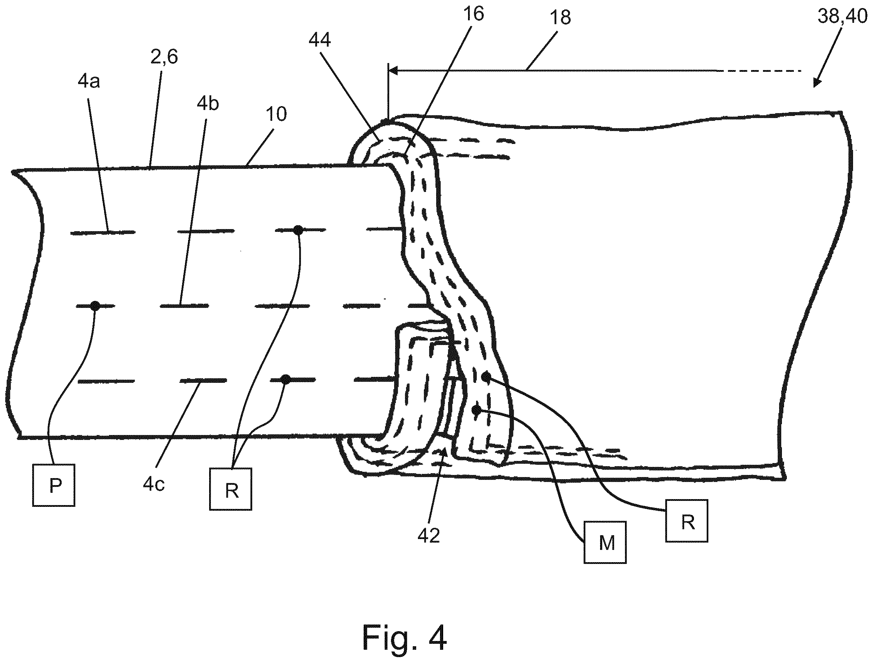

Figur 4 zeigt symbolisch den Hauptstrang 6 des Kabelbaums 2 mit dem Prüfabschnitt 18 und der Elektrode 16. Diese ist hier in Form eines Kupfergeflechts ausgeführt. Die Elektrode 16 ist in einer Manschette 40, hier aus Baumwollstoff, enthalten. Im Beispiel weist die Manschette 40 eine Tasche 38 auf, in die die Elektrode 16 eingelegt ist. Die Manschette 40 wird um den Prüfabschnitt 18 gewickelt bzw. geschlungen, hier in mehr als einer Windung. Wobei die Manschette mit einem nicht näher erläuterten Verschlusselement 42, hier einem Klettverschluss, fixiert ist. Eine Schirmelektrode 44, welche auf Referenzpotential R gelegt ist, umgibt die Elektrode 16 als Abschirmung gegen Störungen. Die Schirmelektrode ist ebenfalls in einer Tasche 38 der Manschette aufgenommen. Beide Elektroden 16,44 sind innerhalb der Manschette 40 durch ein Isoliermittel voneinander elektrisch isoliert, hier eine Lage der Manschette 40 bzw. der Taschen 38, also eine Lage Baumwollstoff.

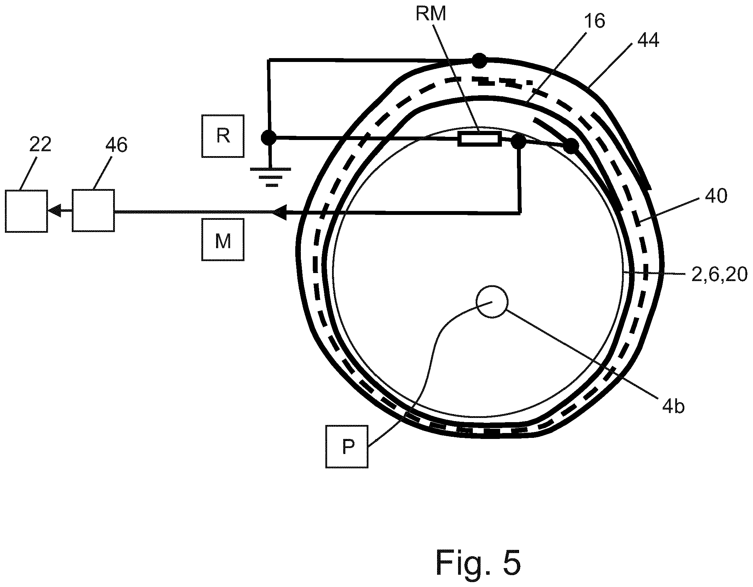

Figur 5 zeigt ein Prinzipschaltbild mit der symbolisch dargestellten Leitung 4b im Leitungsbündel 20 bzw. Hauptstrang 6 des Kabelbaums 2, um welchen die Manschette 40 gewickelt ist. Die Stofftasche bzw. Manschette 40 ist nur gestrichelt angedeutet. Das Potential M wird über einen Messwiderstand RM zum Referenzpotential R geführt und gleichzeitig - angedeutet durch einen Pfeil - zur Steuer- und Auswerteeinheit 22 bzw. zu einem vorgeschalteten Messverstärker 46, wie er weiter unten erläutert wird, geführt. Das Prüfsignal P wird der Leitung 4b zugeführt. Die Elektrode 16 ist hier als Sensorfolie ausgeführt.

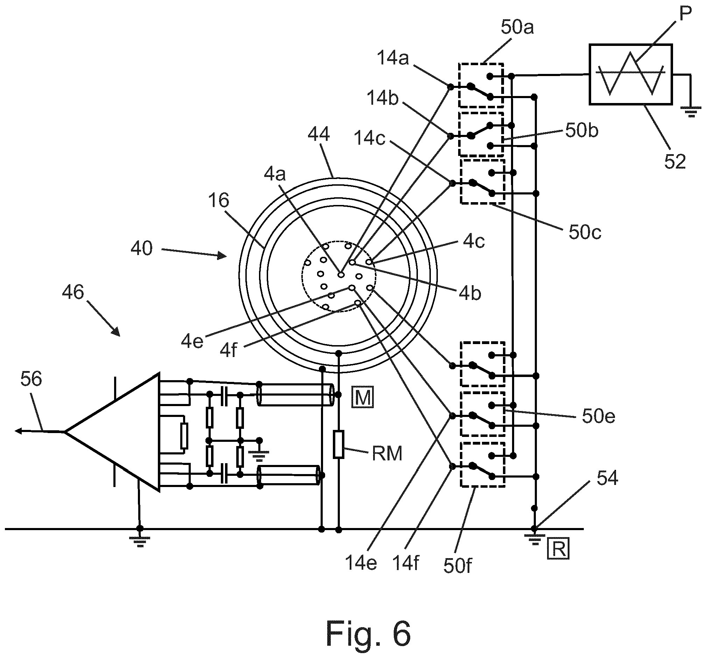

Figur 6 zeigt die Messvorrichtung 12 in höherem Detaillierungsgrad. Von den vielen Leitungen 4 sind beispielhaft nur sechs Leitungen 4a-f durchnummeriert. Alle Leitungen 4a - f sind mit jeweiligen Schaltelementen 50a - f verbunden. Die Messvorrichtung enthält eine Signalquelle 52 für das Prüfsignal P sowie einen Potentialanschluss 54 zur Bereitstellung des Referenzpotentials R. Für jedes der Kupplungselemente 14a - f ist eines der Schaltelemente 50a - f vorgesehen. Das Schaltelement 50a befindet sich hier in einer ersten Schaltstellung, um das Kupplungselement 14a mit der Signalquelle 52 zu verbinden. Sämtliche anderen Schaltelemente 50b - f befinden sich in einer zweiten Schaltstellung, um die jeweiligen Kupplungselemente 14b - f mit dem Potentialanschluss 54 zu verbinden. Durch einfaches Umschalten der Schaltelemente 50a - f kann so wahlweise jede der Leitungen 4 entweder mit der Signalquelle 52 oder mit dem Potentialanschluss 54 verbunden werden. Die Schaltelemente 50a-f können als Relais oder Halbleiterschalter realisiert werden.

Zum anderen zeigt Figur 6 die Beschaltung der Elektrode 16 mit einem nicht näher erläuterten Messverstärker 46, welcher über geschirmte Abgriffsleitungen sowohl das Potential M der Elektrode 16 als auch das Referenzpotential R erfasst und das Potential M als Messsignal verstärkt an seinem Signalausgang 56 zur Verfügung stellt. Dieser Signalausgang 56 speist sein Signal beispielsweise in die Abtasteinheit 26 gemäß Figur 2 ein.

Der Sensor 16 ist wieder als Manschette 40 mit Elektrode 18 und Schirmelektrode 44 aus Kupfergeflecht aufgebaut. Die mit dem Prüfsignal P angesteuerte Ader bzw. Leitung 4b bildet mit dem inneren Kupfergeflecht, also der Elektrode 16 eine Kapazität. Das äußere Kupfergeflecht, also die Schirmelektrode 44 liegt als Abschirmung auf Masse bzw. Referenzpotential R. Das Sensorsignal, also das Potential M wird an dem Messwiderstand RM abgenommen und mit dem Instrumentierungsverstärker bzw. Messverstärker 46 auf einen Pegel für eine weitere digitale Weiterverarbeitung gebracht.

Die Schaltelemente 50a - f werden immer so betrieben, dass stets nur eine Ader bzw. Leitung 4 mit dem Prüfsignal P angesteuert wird, alle anderen auf das Referenzpotential R geschaltet werden. Manschette 40 bzw. Elektrode 16 sind im bestimmungsgemäßen Montagezustand Z dargestellt, in dem diese den Prüfabschnitt 18 und damit auch jede der darin verlaufenden Leitungen 4 nach Art einer Zylindermantelfläche umgeben. Elektrode 16 und jede der Leitungen 4 bilden daher jeweils einen Zylinderkondensator, wobei die Leitung nicht im Zentrum des Zylinderkondensators verlaufen muss. Dies führt zu einer für die Praxis ausreichend großen Kapazität des jeweils gebildeten Kondensators.

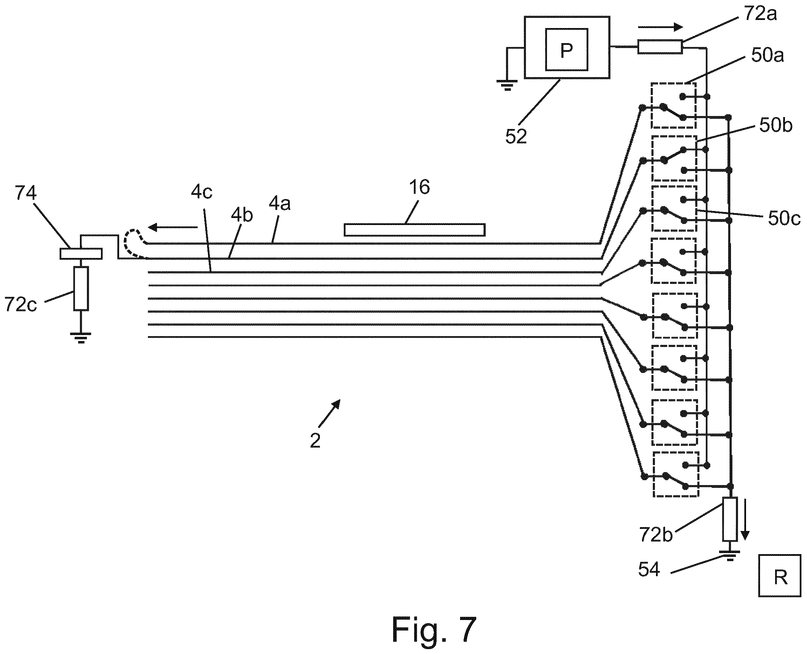

Figur 7 zeigt stilisiert einen Kabelbaum 2 mit Leitungen 4a,b,c,... Hier ist die Signalquelle 52 über einen Vorwiderstand 72a an den Schaltelementen 50a,b,c,... angeschlossen. Auch der Potentialanschluss 54 ist über einen Vorwiderstand 72b an den Schaltelementen 50a,b,c,... angeschlossen.

Die Figur zeigt einen Fehlerfall, nämlich einen Kurzschluss der Leitung 4b mit einem Ablageelement 74, hier einem Messtisch, auf dem das betreffende Ende des Kabelbaumes aufliegt. Das Ablageelement 74 ist ebenfalls über einen Vorwiderstand 72c bezüglich ihres Potentials gegenüber dem Referenzpotential R bzw. Masse oder Erde abgekoppelt. Das Prüfsignal P fällt daher über den Widerständen 72a und 72c ab. An der Leitung 4b liegt also einen Spannung an. Eine Elektrode 16 kann ein Messsignal in Form des Potentials M aufnehmen und die Leitung 4a detektiert werden.

Die Figur zeigt gestrichelt einen alternativen Fehlerfall, nämlich einen Kurzschluss zwischen den Leitungen 4a und 4b an den Leitungsenden auf dem Ablageelement 74. Das Prüfsignal P fällt daher über den Widerständen 72a und 72b ab. An der Leitung 4b liegt also eine Spannung an. Eine Elektrode 16 kann ein Messsignal in Form des Potentials M aufnehmen und die Leitung 4b detektiert werden.

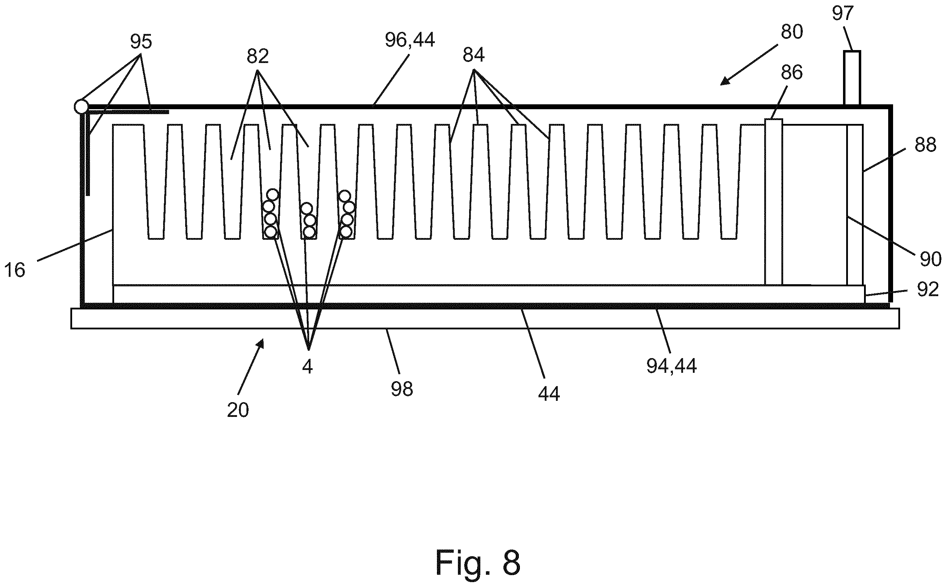

Figur 8 zeigt eine Elektrode 16 in Form einer Mehrfachstruktur 80, hier als Kammstruktur, im Querschnitt, die insgesamt siebzehn Messkammern 82 aufweist. Hierzu weist die Mehrfachstruktur 80 insgesamt achtzehn Kammzähne 84 der Kammstruktur auf. Zwischen jeweils zweien der Kammzähne 84 ist eine der Messkammern 82 gebildet.

Die Mehrfachstruktur 80 ist hier als (in der Figur oben) einseitig offene Kammstruktur ausgebildet. In jede der Messkammern sind als jeweilige "Teilbündel" etliche der Leitungen 4 (von der offenen Seite her, also in der Figur von oben) eingelegt, hier nur beispielhaft für einige angedeutet. Im Beispiel wird das gesamte Leitungsbündel 20 auf siebzehn Teile bzw. Teilbündel aufgeteilt und vollständig - möglichst gleichverteilt - in die Messkammern 82 eingelegt. So kann jede der Leitungen 4 ohne Zwischenlage anderer Leitungen 4 mit der Elektrode 16 einen jeweiligen Kondensator C ausbilden (in der Figur nur beispielhaft angedeutet).

Figur 8 zeigt damit einen sogenannten "Kammsensor". Die Mehrfachstruktur 80 ist hier konkret durch einen handelsüblichen Kühlkörper mit den beispielhaften Abmessungen Breite 250 mm, Tiefe 150 mm, Höhe 50 mm gebildet. In der Figur rechts am Kammsensor bzw. der Mehrfachstruktur 80 ist eine PVC-Isolierplatte 86 montiert. Auf dieser Platte ist ein Verstärkergehäuse 88 (z.B. mit nicht gezeigten Kunststoffschrauben) isoliert befestigt. Z.B. mit einer nicht gezeigten Messingschraube wird der elektrische Kontakt vom Kammsensor zum Verstärker 90 im Verstärkergehäuse 88 hergestellt. Die Mehrfachstruktur 80 ist auf einer weiteren PVC-Isolierplatte 92 befestigt.

Ein Rahmen für den Kammsensor besteht aus zwei Aluminium-Winkeln 94,96 wobei der obere die Funktion eines Deckels 96 übernimmt. Der Deckel 96 ist links mit einem Scharnier 95 angeschlagen und lässt sich mit Hilfe eines Griffs 97 um 180° öffnen. Der Bodenwinkel als Bodenplatte 94 bzw. Bodenblech wird auf einer weiteren PVC-Isolierplatte 98 befestigt. Ein Überstand rechts und links beträgt insgesamt z.B. 20 mm (je 10mm).

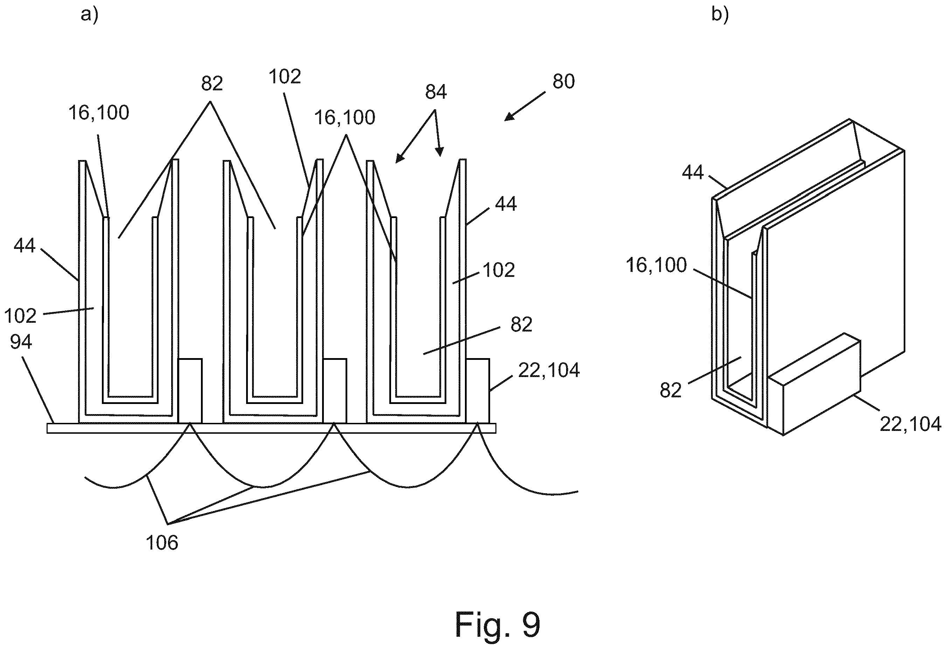

Figur 9 zeigt eine Variante der Elektrode 16 als Mehrfachstruktur 80, bei der die Kammstruktur voneinander getrennte Elektrodenabschnitte 100 aufweist. Figur 9a zeigt beispielhaft nur einen Ausschnitt, nämlich drei der Elektrodenabschnitte 100 im Querschnitt. Figur 9b zeigt perspektivisch lediglich einen der Elektrodenabschnitte 100. Jeder der Elektrodenabschnitte 100 bildet genau eine der Messkammern 82.

In die Messkammern 82 werden die Adern (Leitungen 4) eines Teilkabelbaums (Leitungsbündel 20) einzeln eingelegt. Jede der Messkammern 82 ist umgeben von einem äußeren Abschirmgehäuse in Form einer Schirmelektrode 44. Die Isolierung zwischen Messkammer 82 und Schirmelektrode 44 ist so gestaltet, dass sich die einzulegende Ader (Leitung 4) nicht zwischen Messkammer 82 und Schirmelektrode 44 "verirren" kann, nämlich durch eine geschlossene und abgeschrägte Form des Isoliermaterials 102. Das Abschirmgehäuse (Schirmelektrode 44) ist höher und auch tiefer als die Messkammer 82, so kann optional ein (in Fig. 9 nicht dargestellter) abschirmender Deckel 96, wie er in Fig. 8 dargestellt ist, entfallen.

Jede Messkammer 82 bzw. Elektrodenabschnitt 100 hat ihre eigene Messelektronik in Form eines Messmoduls 104. Eine gemeinsame Grundplatte bzw. Bodenplatte 94 ist als Masseplatte ausgeführt. Die einzelnen Kammersensoren (gebildet aus Elektrodenabschnitt 100, Schirmelektrode 44, Isoliermaterials 102, Messmoduls 104) werden auf die gemeinsame, geerdete Grundplatte bzw. Bodenplatte 94 montiert.

Ein Buskabel 106 mit integrierter Stromversorgung verbindet die einzelnen Messmodule 104 mit einer nicht dargestellten Zentraleinheit, wobei die Gesamtheit aus diesen Komponenten die hier nur angedeutete Steuer- und Auswerteeinheit 22 bildet. Jede Messkammer 82 bzw. Elektrodenabschnitt 100 erhält daher als Messmodul 104 einen Sensorverstärker und zusätzlich einen Mikrokontroller, der das Sensorsignal des Elektrodenabschnitts 100 abtastet, digitalisiert und diese Daten über eine Kommunikations-Schnittstelle (Datenbus bzw. Buskabel 106) an die "Signalverarbeitung" (restliche bzw. Zentralmodul der Steuer- und Auswerteeinheit 22) weitergibt.

### Bezugszeichenliste

- 2: Kabelbaum,
- 4a-f: Leitung
- 6: Hauptstrang
- 8: Abzweigstrang
- 10: Umhüllung
- 12: Messvorrichtung
- 14a-f: Kupplungselement
- 16: Elektrode
- 18: Prüfabschnitt
- 20: Leitungsbündel
- 22: Steuer- und Auswerteeinheit
- 24: Ausgangsschnittstelle
- 26: Abtasteinheit
- 28: Filter
- 30: Multiplikator
- 32: Mittelwerteinheit
- 34: Schwellenwertschalter
- 38: Tasche
- 40: Manschette
- 42: Verschlusselement
- 44: Schirmelektrode
- 46: Messverstärker
- 50a-f: Schaltelement
- 52: Signalquelle
- 54: Potentialanschluss
- 56: Signalausgang
- 60: Verbindungselement
- 62: Kontaktierungsmittel
- 72a,b: Vorwiderstand
- 74: Ablageelement
- 80: Mehrfachstruktur
- 82: Messkammer
- 84: Kammzahn
- 86: Isolierplatte
- 88: Verstärkergehäuse
- 90: Verstärker
- 92: Isolierplatte
- 94: Bodenplatte
- 95: Scharnier
- 96: Deckel
- 97: Griff
- 98: Isolierplatte
- 100: Elektrodenabschnitt
- 102: Isoliermaterial
- 104: Messmodul
- 106: Buskabel

- P: Prüfsignal
- R: Referenzpotential
- E: Entscheidung
- Ca-c: Kondensator
- M: Potential (Messgröße)
- K: Kenngröße
- T: Testkriterium
- J: Ja-Wert
- N: Nein-Wert
- A: Mittelwert-Signal
- Z: Montagezustand
- RM: Messwiderstand
- F: Faktor

## Patentansprüche

1. Verfahren zum Überprüfen eines Kabelbaumes (2), der eine Mehrzahl von elektrischen Leitungen (4a-f) enthält, wobei
- ein Prüfabschnitt (18) des Kabelbaumes (2) gewählt wird, der ein Leitungsbündel mit Leitungen (4a-f) ist,
- eine Elektrode (16) einer Messvorrichtung (12) am Prüfabschnitt (18) angeordnet wird, wobei die Elektrode (16) mit jeder der Leitungen (4a-f) des Leitungsbündels im Prüfabschnitt (18) einen jeweiligen Kondensator (Ca-c) bildet,
- eine der Leitungen (4a-f) des Kabelbaumes (2) als aktuelle Prüfleitung gewählt wird,
- an den verbleibenden Leitungen (4a-f) des Kabelbaumes (2) ein elektrisches Referenzpotential (R) angelegt wird,
- an der Prüfleitung ein elektrisches Prüfsignal (P) angelegt wird und anhand des elektrischen Potentials (M) der Elektrode (16) eine Kenngröße (K) ermittelt wird,
- eine Entscheidung (E) getroffen wird:
- dass die Prüfleitung im Prüfabschnitt (18) liegt, wenn die Kenngröße (K) ein Testkriterium (T) erfüllt, oder
- dass die Prüfleitung nicht im Prüfabschnitt (18) liegt, wenn die Kenngröße (K) das Testkriterium (T) nicht erfüllt,
**dadurch gekennzeichnet, dass**
zumindest ein Teil der Elektrode (16) als Mehrfachstruktur (80) ausgebildet ist, die mindestens zwei Messkammern (82) aufweist, wobei in jede der Messkammern (82) mindestens eine der Leitungen (4a-f) des Leitungsbündels eingelegt wird.

2. Verfahren nach Anspruch 1,
**dadurch gekennzeichnet, dass** eine der Leitungen (4a-f) im Kabelbaum (2) eine Schirmleitung für mindestens eine weitere geschirmte Leitung (4a-f) des Kabelbaums ist, und
- an die Schirmleitung das Referenzpotential (R) angelegt wird, wenn keine der geschirmten Leitungen (4a-f) die aktuelle Prüfleitung ist, oder
- die Schirmleitung leerlaufend gehalten wird, wenn eine der geschirmten Leitungen (4a-f) die Prüfleitung ist.

3. Verfahren nach einem der vorhergehenden Ansprüche,
**dadurch gekennzeichnet, dass**
der Kondensator (C) dadurch gebildet wird, dass die Elektrode (16) das Leitungsbündel im Prüfabschnitt (18) zumindest teilweise umgreift.

4. Verfahren nach einem der vorhergehenden Ansprüche,
**dadurch gekennzeichnet, dass**
eine elektrische Schirmelektrode (44) an der Elektrode (16) angeordnet wird, wobei die Schirmelektrode (44) die Elektrode (16) zu einem Außenraum hin zumindest teilweise umgibt.

5. Verfahren nach einem der vorhergehenden Ansprüche,
**dadurch gekennzeichnet, dass**
die Kenngröße (K) anhand einer Amplitude des Potentials (M) der Elektrode (16) ermittelt wird, und das Testkriterium (T) ein Erreichen eines Grenzwertes der Kenngröße (K) enthält.

6. Verfahren nach einem der vorhergehenden Ansprüche,
**dadurch gekennzeichnet, dass**
die Kenngröße (K) anhand einer Störfilterung und/oder einer gleitenden Mittelwertbildung ermittelt wird.

7. Verfahren nach einem der vorhergehenden Ansprüche,
**dadurch gekennzeichnet, dass**
die Kenngröße (K) anhand eines Verlaufs des Potentials (M) der Elektrode (16) über der Zeit ermittelt wird, und das Testkriterium (K) das Erreichen eines minimalen Korrelationsmaßes mit dem Zeitverlauf des Prüfsignals (P) enthält.

8. Verfahren nach einem der vorhergehenden Ansprüche,
**dadurch gekennzeichnet, dass**
für die Überprüfung der gewählten Prüfleitung höchstens zehn Perioden eines periodischen Prüfsignals (P) angelegt werden und dann die Entscheidung (E) getroffen wird, und anschließend nach einer Pause ohne Prüfsignal (P) eine andere der Leitungen (4a-f) als Prüfleitung gewählt wird.

9. Verfahren nach einem der vorhergehenden Ansprüche,
**dadurch gekennzeichnet, dass**
das Prüfsignal (P) und das Referenzpotential (R) über einen Vorwiderstand (72a,b) an der jeweiligen Leitung (4a-f) angelegt werden, und ein elektrisch zugänglicher Anschluss der Leitung (4a-f) auf einem Ablageelement (74) abgelegt wird, wobei das Ablageelement (74) elektrisch isoliert oder über einen Vorwiderstand (72c) mit dem Referenzpotential (R) verbunden wird.

10. Messvorrichtung (12) zum Überprüfen eines Kabelbaumes (2), der eine Mehrzahl von elektrischen Leitungen (4a-f) enthält,
- mit einer Mehrzahl von Kupplungselementen (14a-f) zur jeweiligen elektrischen Kontaktierung einer der Leitungen (4a-f), wobei
- die Messvorrichtung (12) eine Elektrode (16) enthält, die an einem Prüfabschnitt (18) des Kabelbaumes (2) anordenbar ist, wobei die Elektrode (16) mit jeder der Leitungen (4a-f) des Leitungsbündels im Prüfabschnitt (18) einen jeweiligen Kondensator (Ca-c) bildet, wobei der Prüfabschnitt (18) des Kabelbaumes (2) ein Leitungsbündel mit Leitungen (4a-f) des Kabelbaumes (2) ist,
- mit einer Steuer- und Auswerteeinheit (22),
- die mit den Kupplungselementen (14a-f) verschaltet ist, um wahlweise ein elektrisches Prüfsignal (P) oder ein elektrisches Referenzpotential (R) am Kupplungselement (14a-f) bereitzustellen, und
die mit der Elektrode (16) verschaltet ist, und
- die dazu ausgebildet ist, Steuer- und Auswertungsschritte eines Verfahrens nach einem der Ansprüche 1 bis 9 durchzuführen,
- die Messvorrichtung (12) eine Ausgangsschnittstelle (24) für die Ausgabe der Entscheidung (E) aufweist,
**dadurch gekennzeichnet, dass**
zumindest ein Teil der Elektrode (16) als Mehrfachstruktur (80) ausgebildet ist, die mindestens zwei Messkammern (82) aufweist, wobei in jede der Messkammern (82) mindestens eine der Leitungen (4a-f) des Leitungsbündels einlegbar ist.

11. Messvorrichtung (12) nach Anspruch 10,
**dadurch gekennzeichnet, dass**
mindestens eine der Leitungen (4a-f) ein Verbindungselement (60) zur elektrischen Kontaktierung der jeweiligen Leitung (4a-f) aufweist, und
das Kupplungselement (14a-f) ein Kontaktierungsmittel (62) zur elektrischen Kontaktierung des Verbindungselements (60) aufweist.

12. Messvorrichtung (12) nach einem der Ansprüche 10 bis 11,
**dadurch gekennzeichnet, dass**
die Elektrode (16) zumindest teilweise um den Prüfabschnitt (18) des Kabelbaumes (2) schlingbar ist.

13. Messvorrichtung (12) nach einem der Ansprüche 10 bis 12,
**dadurch gekennzeichnet, dass**
die Messvorrichtung (12) eine Manschette (40) enthält, in der die Elektrode (16) aufgenommen ist.

14. Messvorrichtung (12) nach Anspruch 13,
**dadurch gekennzeichnet, dass**
die Manschette (40) eine Schirmelektrode (44) enthält, die von der Elektrode (16) elektrisch isoliert ist und die im bestimmungsgemäßen Montagezustand (Z) der Manschette (40) am Prüfabschnitt (18) die Elektrode (16) zumindest teilweise umgibt.

15. Messvorrichtung (12) nach einem der Ansprüche 10 bis 14,
**dadurch gekennzeichnet, dass**
die Messvorrichtung (12) eine Signalquelle (52) zur Bereitstellung des Prüfsignals (P) und einen Potentialanschluss (54) zur Bereitstellung des Referenzpotentials (R) enthält, und jeweilige Schaltelemente (50a-f) für jedes der Kupplungselemente (14a-f) enthält, die in einer erster Schaltstellung das Kupplungselement (14a-f) mit der Signalquelle (52) verbinden, und in einer zweiten Schaltstellung das Kupplungselement (14a-f) mit dem Potentialanschluss (54) verbinden.

16. Messvorrichtung (12) nach einem der Ansprüche 10 bis 15,
**dadurch gekennzeichnet, dass**
die Mehrfachstruktur (80) als einseitig offene Kammstruktur ausgebildet ist, wobei die Messkammern (82) als Messkammern (82) zwischen jeweils zwei der Kammzähne (84) der Kammstruktur gebildet sind.

17. Messvorrichtung (12) nach einem der Ansprüche 10 bis 16,
**dadurch gekennzeichnet, dass**
die Mehrfachstruktur (80) mindestens zwei voneinander getrennte Elektrodenabschnitte (100) aufweist, wobei jeder der Elektrodenabschnitte (100) mindestens eine der Messkammern (82) bildet.

## Claims

1. A method for checking a cable harness (2) which includes a plurality of electric lines (4a-f), wherein
- a test section (18) of the cable harness (2) is selected, which is a group of lines with lines (4a-f),
- an electrode (16) of a measuring apparatus (12) is arranged on the test section (18), wherein the electrode (16) forms a respective capacitor (Ca-c) with each of the lines (4a-f) of the group of lines in the test section (18),
- one of the lines (4a-f) of the cable harness (2) is selected as the current test line,
- an electrical reference potential (R) is applied to the remaining lines (4a-f) of the cable harness (2),
- an electrical test signal (P) is applied to the test line, and a characteristic variable (K) is determined on the basis of the electrical potential (M) of the electrode (16),
- a decision (E) is made:
- that the test line is in the test section (18) if the characteristic variable (K) meets a test criterion (T), or
- that the test line is not in the test section (18) if the characteristic variable (K) does not meet the test criterion (T),
**characterised in that**
at least a part of the electrode (16) is configured as a multiple structure (80) which has at least two measuring chambers (82), wherein at least one of the lines (4a-f) of the group of lines is inserted into each of the measuring chambers (82).

2. The method according to Claim 1,
**characterised in that**
one of the lines (4a-f) in the cable harness (2) is a shield line for at least one further shielded line (4a-f) of the cable harness, and
- the reference potential (R) is applied to the shield line if none of the shielded lines (4a-f) is the current test line, or
- the shield line is kept open-circuited if one of the shielded lines (4a-f) is the test line.

3. The method according to any one of the preceding claims,
**characterised in that**
the capacitor (C) is formed **in that** the electrode (16) at least partially encompasses the group of lines in the test section (18).

4. The method according to any one of the preceding claims,
**characterised in that**
an electrical shield electrode (44) is arranged on the electrode (16), wherein the shield electrode (44) at least partially encloses the electrode (16) towards an external space.

5. The method according to any one of the preceding claims,
**characterised in that**
the characteristic variable (K) is determined on the basis of an amplitude of the potential (M) of the electrode (16), and the test criterion (T) includes the attainment of a limit of the characteristic variable (K).

6. The method according to any one of the preceding claims,
**characterised in that**
the characteristic variable (K) is determined on the basis of noise filtering and/or a moving averaging process.

7. The method according to any one of the preceding claims,
**characterised in that**
the characteristic variable (K) is determined on the basis of a course of the potential (M) of the electrode (16) over time, and the test criterion (K) includes the attainment of a minimum correlation measure with the passage of time of the test signal (P).

8. The method according to any one of the preceding claims,
**characterised in that**
a maximum of ten periods of a periodic test signal (P) are applied in order to check the selected test line, and then the decision (E) is made, and following a pause without a test signal (P) another of the lines (4a-f) is subsequently selected as the test line.

9. The method according to any one of the preceding claims,
**characterised in that**
the test signal (P) and the reference potential (R) are applied via a series resistor (72a,b) to the respective line (4a-f), and an electrically accessible connection of the line (4a-f) is stored on a storage element (74), wherein the storage element (74) is electrically insulated or is connected to the reference potential (R) via a series resistor (72c).

10. A measuring apparatus (12) for checking a cable harness (2) which includes a plurality of electric lines (4a-f),
- having a plurality of coupling elements (14a-f) for making respective electrical contact with one of the lines (4a-f),
wherein
- the measuring apparatus (12) includes an electrode (16) which can be arranged on a test section (18) of the cable harness (2), wherein the electrode (16) forms a respective capacitor (Ca-c) with each of the lines (4a-f) of the group of lines in the test section (18), wherein the test section (18) of the cable harness (2) is a group of lines with lines (4a-f) of the cable harness (2),
- having a control and evaluation unit (22)
- which is interconnected with the coupling elements (14a-f) in order to selectively provide an electrical test signal (P) or an electrical reference potential (R) to the coupling element (14a-f), and which is interconnected with the electrode (16), and
- which is configured to carry out control and evaluation steps of a method according to any one of Claims 1 to 9,
- the measuring apparatus (12) has an output interface (24) for outputting the decision (E),
**characterised in that**
at least a part of the electrode (16) is configured as a multiple structure (80) which has at least two measuring chambers (82), wherein at least one of the lines (4a-f) of the group of lines can be inserted into each of the measuring chambers (82).

11. The measuring apparatus (12) according to Claim 10,
**characterised in that**
at least one of the lines (4a-f) has a connecting element (60) for making electrical contact with the respective line (4a-f), and the coupling element (14a-f) has a contacting means (62) for making electrical contact with the connecting element (60).

12. The measuring apparatus (12) according to any one of Claims 10 to 11,
**characterised in that**
the electrode (16) can be at least partially looped around the test section (18) of the cable harness (2).

13. The measuring apparatus (12) according to any one of Claims 10 to 12,
**characterised in that**
the measuring apparatus (12) includes a sleeve (40), in which the electrode (16) is received.

14. The measuring apparatus (12) according to Claim 13,
**characterised in that**
the sleeve (40) comprises a shield electrode (44) which is electrically insulated from the electrode (16) and which, when the sleeve (40) is in the intended mounted state (Z) on the test section (18), at least partially encloses the electrode (16).

15. The measuring apparatus (12) according to any one of Claims 10 to 14,
**characterised in that**
the measuring apparatus (12) includes a signal source (52) for providing the test signal (P) and a potential terminal (54) for providing the reference potential (R), and includes respective switching elements (50a-f) for each of the coupling elements (14a-f) which, in a first switch position, connect the coupling element (14a-f) to the signal source (52) and, in a second switch position, connect the coupling element (14a-f) to the potential terminal (54).

16. The measuring apparatus (12) according to any one of Claims 10 to 15,
**characterised in that**
the multiple structure (80) is configured as a comb structure which is open on one side, wherein the measuring chambers (82) are formed as measuring chambers (82) between, in each case, two of the comb teeth (84) of the comb structure.

17. The measuring apparatus (12) according to any one of Claims 10 to 16,
**characterised in that**
the multiple structure (80) has at least two electrode portions (100) which are separate from one another, wherein each of the electrode portions (100) forms at least one of the measuring chambers (82).

## Revendications

1. Procédé de contrôle d'un harnais de câbles (2) comprenant une pluralité de lignes électriques (4a-f), où
- un segment de contrôle (18) du harnais de câbles (2) est sélectionné, lequel est un faisceau de lignes comprenant les lignes (4a-f),
- une électrode (16) d'un dispositif de mesure (12) est disposée sur le segment de contrôle (18), ladite électrode (16) formant un condensateur correspondant (Ca-c) avec chacune des lignes (4a-f) du faisceau de lignes dans le segment de contrôle (18),
- une des lignes (4a-f) du harnais de câbles (2) est sélectionnée comme ligne de contrôle actuelle,
- un potentiel de référence électrique (R) est appliqué sur les lignes restantes (4a-f) du harnais de câbles (2),
- un signal de test électrique (P) est appliqué sur la ligne de contrôle et une grandeur caractéristique (K) est déterminée à partir du potentiel électrique (M) de l'électrode (16),
- une décision (E) est prise :
- suivant laquelle la ligne de contrôle est présentée dans le segment de contrôle (18) si la grandeur caractéristique (K) satisfait à un critère de test (T), ou
- suivant laquelle la ligne de contrôle n'est pas présentée dans le segment de contrôle (18) si la grandeur caractéristique (K) ne satisfait pas au critère de test (T),
**caractérisé**
**en ce qu'**au moins une partie de l'électrode (16) est réalisée comme structure multiple (80) présentant au moins deux chambres de mesure (82), au moins une des lignes (4a-f) du faisceau de lignes étant posée dans chacune des chambres de mesure (82).

2. Procédé selon la revendication 1,
**caractérisé**
**en ce qu'**une des lignes (4a-f) du harnais de câbles (2) est une ligne de blindage pour au moins une autre ligne blindée (4a-f) du harnais de câbles, et
- **en ce que** le potentiel de référence (R) est appliqué sur la ligne de blindage si aucune des lignes blindées (4a-f) n'est la ligne de contrôle actuelle, ou
- la ligne de blindage est maintenue en circuit ouvert si une des lignes blindées (4a-f) est la ligne de contrôle.

3. Procédé selon l'une quelconque des revendications précédentes,
**caractérisé**
**en ce que** le condensateur (C) est formé **en ce que** l'électrode (16) enveloppe au moins partiellement le faisceau de lignes dans le segment de contrôle (18).

4. Procédé selon l'une quelconque des revendications précédentes,
**caractérisé**
**en ce qu'**une électrode écran électrique (44) est disposée contre l'électrode (16), ladite électrode écran (44) entourant au moins partiellement l'électrode (16) vers un espace extérieur.

5. Procédé selon l'une quelconque des revendications précédentes,
**caractérisé**
**en ce que** la grandeur caractéristique (K) est déterminée sur la base d'une amplitude du potentiel (M) de l'électrode (16), et **en ce que** le critère de test (T) comprend l'atteinte d'une valeur limite de la grandeur caractéristique (K).

6. Procédé selon l'une quelconque des revendications précédentes,
**caractérisé**
**en ce que** la grandeur caractéristique (K) est déterminée sur la base d'un filtrage de bruit et/ou d'une formation de moyenne glissante.

7. Procédé selon l'une quelconque des revendications précédentes,
**caractérisé**
**en ce que** la grandeur caractéristique (K) est déterminée sur la base d'une courbe temporelle du potentiel (M) de l'électrode (16), et **en ce que** le critère de test (K) comprend l'atteinte d'une mesure minimale de corrélation avec la courbe temporelle du signal de test (P).

8. Procédé selon l'une quelconque des revendications précédentes,
**caractérisé**
**en ce que** pour le contrôle de la ligne de contrôle sélectionnée, sont appliquées au maximum dix périodes d'un signal de test (P) périodique, la décision (E) étant alors prise, et une autre des lignes (4a-f) étant ensuite sélectionnée comme ligne de contrôle après une pause sans signal de test (P).

9. Procédé selon l'une quelconque des revendications précédentes,
**caractérisé**
**en ce que** le signal de test (P) et le potentiel de référence (R) sont appliqués par une résistance série (72a, b) sur la ligne (4a-f) correspondante, et une connexion électriquement accessible de la ligne (4a-f) est déposée sur un élément de réception (74), ledit élément de réception (74) étant isolé électriquement ou relié au potentiel de référence (R) par une résistance série (72c).

10. Dispositif de mesure (12) pour le contrôle d'un harnais de câbles (2) comprenant une pluralité de lignes électriques (4a-f),
- avec une pluralité d'éléments de couplage (14a-f) destinés chacun au contact électrique d'une des lignes (4a-f),
où
- ledit dispositif de mesure (12) comprend une électrode (16) pouvant être disposée sur un segment de contrôle (18) du harnais de câbles (2), ladite électrode (16) formant un condensateur correspondant (Ca-c) avec chacune des lignes (4a-f) du faisceau de lignes dans le segment de contrôle (18), le segment de contrôle (18) du harnais de câbles (2) étant un faisceau de lignes comprenant les lignes (4a-f) du harnais de câbles (2),
- avec une unité de commande et d'analyse (22),
- laquelle est reliée aux éléments de couplage (14a-f) pour délivrer au choix un signal de test électrique (P) ou un potentiel de référence électrique (R) à l'élément de couplage (14a-f), et est reliée à l'électrode (16), et
- est prévue pour exécuter les étapes de commande et d'analyse d'un procédé selon l'une des revendications 1 à 9,
- ledit dispositif de mesure (12) présentant une interface de sortie (24) pour la transmission de la décision (E),
**caractérisé**
**en ce qu'**au moins une partie de l'électrode (16) est réalisée comme structure multiple (80) présentant au moins deux chambres de mesure (82), au moins une des lignes (4a-f) du faisceau de lignes pouvant être posée dans chacune des chambres de mesure (82).

11. Dispositif de mesure (12) selon la revendication 10,
**caractérisé**
**en ce qu'**au moins une des lignes (4a-f) présente un élément de connexion (60) pour le contact électrique de la ligne (4a-f) correspondante, et **en ce que** l'élément de couplage (14a-f) présente un moyen de contact (62) pour le contact électrique de l'élément de connexion (60).

12. Dispositif de mesure (12) selon la revendication 10 ou la revendication 11,
**caractérisé**
**en ce que** l'électrode (16) est enroulable au moins partiellement autour du segment de contrôle (18) du harnais de câbles (2).

13. Dispositif de mesure (12) selon l'une des revendications 10 à 12,
**caractérisé**
**en ce que** ledit dispositif de mesure (12) comprend une manchette (40) où est logée l'électrode (16).

14. Dispositif de mesure (12) selon la revendication 13,
**caractérisé**
**en ce que** la manchette (40) comprend une électrode écran (44) électriquement isolée de l'électrode (16) et entourant au moins partiellement l'électrode (16) en état de montage (Z) conforme à sa destination de la manchette (40) sur le segment de contrôle (18).

15. Dispositif de mesure (12) selon l'une des revendications 10 à 14,
**caractérisé**
**en ce que** ledit dispositif de mesure (12) comprend une source de signaux (52) pour la fourniture du signal de test (P) et une connexion de potentiel (54) pour la fourniture du potentiel de référence (R), et des éléments de commutation correspondants (50a-f) pour chacun des éléments de couplage (14a-f), lesquels relient l'élément de couplage (14a-f) à la source de signaux (52) dans une première position de commutation, et l'élément de couplage (14a-f) à la connexion de potentiel (54) dans une deuxième position de commutation.

16. Dispositif de mesure (12) selon l'une des revendications 10 à 15,
**caractérisé**
**en ce que** la structure multiple (80) est formée comme structure en peigne ouverte sur un côté, les chambres de mesure (82) étant formées chacune comme chambre de mesure (82) entre deux des dents (84) de la structure en peigne.

17. Dispositif de mesure (12) selon l'une des revendications 10 à 16,
**caractérisé**
**en ce que** la structure multiple (80) présente au moins deux segments d'électrode (100) séparés l'un de l'autre (100), chaque segment d'électrode (100) formant au moins une des chambres de mesure (82).
